(19) Europäisches Patentamt / European Patent Office / Office européen des brevets

(11) **EP 3 063 002 B1**

(12) **FASCICULE DE BREVET EUROPEEN**

(45) Date de publication et mention de la délivrance du brevet:
**09.12.2020 Bulletin 2020/50**

(21) Numéro de dépôt: **14825389.1**

(22) Date de dépôt: **29.10.2014**

(51) Int Cl.:
**B32B 17/10** *(2006.01)*  **G03B 21/62** *(2014.01)*

(86) Numéro de dépôt international:
**PCT/FR2014/052752**

(87) Numéro de publication internationale:
**WO 2015/063418 (07.05.2015 Gazette 2015/18)**

(54) **ELEMENT EN COUCHES TRANSPARENT**

ELEMENT AUS TRANSPARENTEN SCHICHTEN

ELEMENT MADE FROM TRANSPARENT LAYERS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **30.10.2013 FR 1360641**

(43) Date de publication de la demande:
**07.09.2016 Bulletin 2016/36**

(73) Titulaire: **SAINT-GOBAIN GLASS FRANCE
92400 Courbevoie (FR)**

(72) Inventeurs:
• **SCHIAVONI, Michele**
  **F-75014 Paris (FR)**
• **EHRENSPERGER, Marie-Virginie**
  **F-73100 Aix Les Bains (FR)**

(74) Mandataire: **Saint-Gobain Recherche
Département Propriété Industrielle
39 Quai Lucien Lefranc
93300 Aubervilliers (FR)**

(56) Documents cités:
**WO-A1-2012/104547  FR-A- 1 559 328**

EP 3 063 002 B1

**Description**

La présente invention a trait à un élément en couches transparent à propriétés de réflexion diffuse.

L'élément en couches peut être rigide ou flexible. Il peut s'agir en particulier d'un vitrage, constitué par exemple à base de verre ou de matériau organique polymérique, susceptible d'être utilisé pour toutes applications connues de vitrages, telles que pour véhicules, bâtiments, mobilier urbain, ameublement intérieur, dispositifs d'éclairage, supports d'affichage, écrans de projection, etc. Il peut s'agir également d'un film flexible à base de matériau organique polymérique, notamment apte à être rapporté sur une surface, par exemple une surface d'un vitrage, afin de lui conférer des propriétés de réflexion diffuse tout en gardant une transmission spéculaire de rayonnement à travers le vitrage.

Au sens de l'invention, un élément en couches transparent à propriétés de réflexion diffuse est un élément qui donne lieu à une transmission spéculaire et une réflexion diffuse d'un rayonnement incident sur l'élément. De manière usuelle, la réflexion par un élément est dite diffuse lorsqu'un rayonnement incident sur l'élément avec un angle d'incidence donné est réfléchi par l'élément dans une pluralité de directions. Au contraire, la réflexion par un élément est dite spéculaire lorsqu'un rayonnement incident sur l'élément avec un angle d'incidence donné est réfléchi par l'élément avec un angle de réflexion égal à l'angle d'incidence. De manière analogue, la transmission à travers un élément est dite diffuse lorsqu'un rayonnement incident sur l'élément avec un angle d'incidence donné est transmis par l'élément dans une pluralité de directions, tandis que la transmission à travers un élément est dite spéculaire lorsqu'un rayonnement incident sur l'élément avec un angle d'incidence donné est transmis par l'élément avec un angle de transmission égal à l'angle d'incidence.

Un élément en couches transparent à propriétés de réflexion diffuse est décrit dans la demande de brevet WO 2012/104547 A1. Lorsqu'un tel élément en couches est incorporé dans un vitrage, celui-ci présente l'avantage de ne pas renvoyer de reflets nets, grâce à la réflexion diffuse, ce qui réduit les risques d'éblouissement, par exemple lorsque des phares de véhicules se reflètent sur le vitrage. De plus, lorsque l'élément en couches est incorporé dans un vitrage séparant un espace relativement plus lumineux, par exemple un espace extérieur, et un espace relativement moins lumineux, par exemple un espace intérieur, le vitrage est perçu comme diffus par un observateur placé du côté le plus lumineux et comme transparent par un observateur placé du côté le moins lumineux. En jouant sur le niveau de diffusion de l'élément en couches, il est ainsi possible d'obtenir un vitrage ayant une apparence à la fois opaque du côté le plus lumineux et transparente du côté le moins lumineux. Un tel vitrage peut trouver application, notamment, en tant que vitrage "privacy" pour des véhicules ou des bâtiments, procurant une intimité à l'intérieur du véhicule ou du bâtiment.

Il a toutefois été constaté que, lorsque le contraste lumineux n'est pas assez marqué entre les deux côtés du vitrage incorporant l'élément en couches, un observateur placé du côté le moins lumineux perçoit une impression de flou ou de "vitrage sale", qui limite la netteté de la vision à travers le vitrage.

C'est à cet inconvénient qu'entend plus particulièrement remédier l'invention en proposant un élément en couches transparent à propriétés de réflexion diffuse permettant d'assurer une vision nette à travers l'élément pour un observateur situé d'un côté donné de l'élément, sans impression de flou ou de "vitrage sale", même lorsque le contraste lumineux entre les deux côtés de l'élément est relativement faible.

A cet effet, l'invention a pour objet un élément en couches transparent ayant deux surfaces principales externes lisses et comprenant :

- deux couches externes, qui ont chacune une surface principale externe lisse et qui sont constituées en des matériaux diélectriques ayant sensiblement le même indice de réfraction, et
- une couche centrale intercalée entre les couches externes, cette couche centrale étant formée soit par une couche unique en matériau métallique ou en matériau diélectrique d'indice de réfraction différent de celui des couches externes, soit par un empilement de couches qui comprend au moins une couche en matériau métallique ou en matériau diélectrique d'indice de réfraction différent de celui des couches externes,

où toutes les surfaces de contact entre deux couches adjacentes de l'élément en couches qui sont l'une en matériau métallique et l'autre en matériau diélectrique, ou qui sont deux couches en matériaux diélectriques d'indices de réfraction différents, sont texturées et parallèles entre elles, caractérisé en ce que le rapport de la réflexion totale de l'élément en couches du côté d'une première couche externe dans un domaine de longueurs d'onde donné sur la réflexion totale de l'élément en couches du côté de la deuxième couche externe dans ledit domaine de longueurs d'onde donné est supérieur ou égal à 1,5, de préférence supérieur ou égal à 2, encore de préférence supérieur ou égal à 3, encore de préférence supérieur ou égal à 4.

La réflexion totale, dans un domaine de longueurs d'onde donné, d'un élément en couches du côté de l'une de ses couches externes, exprimée en %, est mesurée en positionnant la source de rayonnement de telle sorte que le rayonnement est en incidence normale sur l'élément du côté de ladite couche externe. La réflexion totale d'un élément comprend la réflexion spéculaire de l'élément et la réflexion non spéculaire, ou réflexion diffuse, de l'élément. De préférence, le domaine de longueurs d'onde donné comprend au moins une partie du domaine de longueurs d'onde du

**EP 3 063 002 B1**

visible. En particulier, il peut s'agir de tout ou partie du domaine de longueurs d'onde du visible, ou d'un domaine incluant des bandes spectrales à la fois dans le domaine de l'infrarouge et dans le domaine du visible.

De manière surprenante, une structure de l'élément en couches présentant une asymétrie en réflexion telle que décrite ci-dessus permet de supprimer l'impression de flou ou de "vitrage sale" pour un observateur placé du côté de la deuxième couche externe. Cela est surprenant car le fait d'avoir une impression de flou lorsqu'on regarde à travers un élément est généralement lié à une propriété de flou en transmission de l'élément, c'est-à-dire à l'aptitude de l'élément à dévier un rayonnement qui le traverse. Dès lors, on aurait pu penser que l'impression de flou ou de "vitrage sale", lorsqu'on observe un élément en couches transparent à propriétés de réflexion diffuse, résulte d'un flou ("haze" en anglais) en transmission dû par exemple à un accord d'indice imparfait entre les deux couches externes de l'élément, ou encore à un parallélisme imparfait des surfaces de contact au sein de l'élément. L'invention va à l'encontre de ce préjugé et supprime l'impression de flou ou de "vitrage sale" en ajustant les propriétés de réflexion de chaque côté de l'élément, plutôt qu'en cherchant à limiter encore le flou en transmission de l'élément.

Ainsi, dans le cadre de l'invention, on obtient une transmission spéculaire du rayonnement incident sur l'élément en couches du côté de la première couche externe, tout en limitant fortement la réflexion de rayonnement incident sur l'élément en couches du côté de la deuxième couche externe. De cette façon, un observateur placé du côté de la deuxième couche externe reçoit principalement la lumière provenant du côté de la première couche externe, qui est transmise à travers l'élément en couches de manière spéculaire quelle que soit la direction de la ou chaque source lumineuse située du côté de la première couche externe. Il en résulte une vision nette à travers l'élément en couches, sans impression de flou ou de "vitrage sale", pour l'observateur placé du côté de la deuxième couche externe, et ce même lorsque le contraste lumineux entre les deux côtés de l'élément est faible ou inexistant, voire même lorsque la luminosité du côté de la deuxième couche externe est plus forte que celle du côté de la première couche externe.

Selon un aspect de l'invention, le rapport de la réflexion lumineuse totale de l'élément en couches du côté d'une première couche externe sur la réflexion lumineuse totale de l'élément en couches du côté de la deuxième couche externe est supérieur ou égal à 1,5, de préférence supérieur ou égal à 2, encore de préférence supérieur ou égal à 3, encore de préférence supérieur ou égal à 4.

Dans le cadre de l'invention, la réflexion lumineuse totale d'un élément en couches du côté de l'une de ses couches externes, exprimée en %, est mesurée selon la norme ISO 9050:2003 (illuminant D65 ; 2° Observateur), en positionnant la source lumineuse de telle sorte que le rayonnement est en incidence normale sur l'élément du côté de ladite couche externe.

Chacune des deux couches externes de l'élément en couches peut être formée par un empilement de couches, pour autant que les différentes couches constitutives de la couche externe soient constituées en des matériaux diélectriques ayant tous sensiblement le même indice de réfraction. Au sens de l'invention, on entend par "couches externes" les deux couches qui encadrent la couche centrale en étant immédiatement adjacentes à celle-ci, étant entendu qu'il ne s'agit pas forcément des couches les plus externes de l'élément en couches. En effet, l'élément en couches peut comprendre, pour chaque couche externe, au moins une couche additionnelle positionnée contre la surface principale externe de cette couche externe.

Dans le cadre de l'invention, un matériau diélectrique est un matériau non métallique. Un matériau diélectrique peut être de nature organique ou minérale. Les matériaux diélectriques de nature minérale peuvent être choisis parmi les oxydes, nitrures ou halogénures d'un ou plusieurs métaux de transition, non-métaux ou métaux alcalino-terreux choisis de préférence parmi le silicium, le titane, l'étain, le zinc, l'aluminium, le molybdène, le niobium, le zirconium, le magnésium. Les matériaux diélectriques organiques peuvent être choisis parmi les polymères.

Au sens de l'invention, deux matériaux diélectriques ont sensiblement le même indice de réfraction, ou ont leurs indices de réfraction sensiblement égaux, lorsque la valeur absolue de la différence entre leurs indices de réfraction à 550 nm est inférieure ou égale à 0,150. De préférence, la valeur absolue de la différence d'indice de réfraction à 550 nm entre les matériaux constitutifs des deux couches externes de l'élément en couches est, par ordre de préférence croissant : inférieure ou égale à 0,050, inférieure ou égale à 0,030, inférieure ou égale à 0,020, inférieure ou égale à 0,015, inférieure ou égale à 0,010, inférieure ou égale à 0,005.

De plus, au sens de l'invention, deux matériaux diélectriques ont des indices de réfraction différents lorsque la valeur absolue de la différence entre leurs indices de réfraction à 550 nm est strictement supérieure à 0,150. De préférence, la valeur absolue de la différence d'indice de réfraction à 550 nm entre, d'une part, les matériaux constitutifs des couches externes et, d'autre part, le matériau constitutif d'au moins une couche diélectrique de la couche centrale, est supérieure ou égale à 0,30, de préférence supérieure ou égale à 0,50, encore de préférence supérieure ou égale à 0,80. Selon l'invention, cette différence d'indice de réfraction relativement importante intervient au niveau d'au moins une surface de contact texturée interne à l'élément en couches. Cela permet de favoriser la réflexion de rayonnement sur cette surface de contact texturée, c'est-à-dire une réflexion diffuse du rayonnement par l'élément en couches.

Dans le cadre de l'invention, on utilise les définitions suivantes.

La surface de contact entre deux couches adjacentes est l'interface entre les deux couches adjacentes.

Un élément transparent est un élément à travers lequel il y a une transmission de rayonnement au moins dans les domaines de longueurs d'onde utiles pour l'application visée de l'élément. A titre d'exemple, lorsque l'élément est utilisé en tant que vitrage de véhicule ou de bâtiment, il est transparent au moins dans le domaine de longueurs d'onde du visible.

Un vitrage est un substrat transparent rigide, organique ou minéral.

Une surface texturée est une surface pour laquelle les propriétés de surface varient à une échelle plus grande que la longueur d'onde du rayonnement incident sur la surface, de sorte que le rayonnement incident est transmis et réfléchi de manière diffuse par la surface. De préférence, une surface texturée, ou rugueuse, présente un paramètre de rugosité correspondant à l'écart moyen arithmétique Ra supérieur ou égal à 0,5 $\mu$m, notamment compris entre 1 $\mu$m et 2 mm. De manière classique, l'écart moyen arithmétique Ra est la moyenne arithmétique de toutes les distances absolues du profil de rugosité R mesurée à partir d'une ligne médiane du profil sur une longueur d'évaluation.

Une surface lisse est une surface pour laquelle les irrégularités de surface sont telles que le rayonnement incident sur la surface n'est pas dévié par ces irrégularités de surface. Le rayonnement incident est alors transmis et réfléchi de manière spéculaire par la surface. En particulier, une surface lisse est une surface pour laquelle les irrégularités de surface sont de dimensions inférieures à la longueur d'onde du rayonnement incident sur la surface, ou sont des ondulations à grande échelle de pentes très faibles, notamment inférieures à 1°.

On note que, si une couche externe est formée par un empilement de couches constituées en des matériaux diélectriques ayant tous sensiblement le même indice de réfraction, c'est la surface principale externe de la couche la plus externe par rapport à la couche centrale qui doit être lisse, étant entendu que les surfaces de contact entre les différentes couches constitutives de la couche externe peuvent ne pas être lisses.

On note également que l'élément en couches selon l'invention peut comprendre au moins une couche additionnelle positionnée contre la surface principale externe d'au moins l'une des deux couches externes, où la couche additionnelle est constituée en un matériau métallique ou en un matériau diélectrique ayant un indice de réfraction différent de celui des matériaux diélectriques des couches externes. Dans ce cas, la surface principale externe de la couche additionnelle doit être lisse.

Selon l'invention, l'absorption de l'élément en couches dans ledit domaine de longueurs d'onde donné pour un rayonnement incident du côté de la deuxième couche externe est strictement supérieure à l'absorption de l'élément en couches dans ledit domaine de longueurs d'onde donné pour un rayonnement incident du côté de la première couche externe.

Grâce à l'invention, on obtient une transmission spéculaire du rayonnement incident sur l'élément en couches du côté de la première couche externe, tout en limitant la réflexion de rayonnement incident sur l'élément en couches du côté de la deuxième couche externe. La transmission spéculaire à travers l'élément en couches provient de ce que les deux couches externes ont des surfaces principales externes lisses et sont constituées en des matériaux ayant sensiblement le même indice de réfraction, de ce que les surfaces principales externes de l'élément en couches sont également lisses, et de ce que toutes les surfaces de contact entre deux couches adjacentes de l'élément en couches qui sont l'une en matériau métallique et l'autre en matériau diélectrique, ou qui sont deux couches en matériaux diélectriques d'indices de réfraction différents, sont texturées et parallèles entre elles, comme expliqué dans la demande WO 2012/104547 A1.

De plus, on obtient une réflexion diffuse d'un rayonnement incident sur l'élément en couches du côté de la première couche externe, de sorte qu'un observateur placé du côté de la première couche externe perçoit l'élément en couches comme diffus, voire opaque. La réflexion diffuse sur l'élément en couches provient de ce que chaque surface de contact entre deux couches adjacentes qui sont l'une métallique et l'autre diélectrique, ou qui sont deux couches diélectriques d'indices de réfraction différents, est texturée. Ainsi, lorsqu'un rayonnement incident sur l'élément en couches atteint une telle surface de contact, il est réfléchi par la couche métallique ou du fait de la différence d'indice de réfraction entre les deux couches diélectriques et, comme la surface de contact est texturée, la réflexion est diffuse.

De préférence, l'espace situé du côté de la première couche externe est plus lumineux que l'espace situé du côté de la deuxième couche externe. En ajustant la réflexion lumineuse totale de l'élément en couches du côté de la première couche externe, il est ainsi possible d'obtenir un élément en couches ayant une apparence à la fois opaque du côté de la première couche externe et transparente du côté de la deuxième couche externe. Un tel élément en couches peut être utilisé, notamment, comme tout ou partie d'un vitrage de type "privacy", en particulier pour véhicule ou bâtiment.

Le parallélisme des surfaces de contact texturées implique que, pour chaque couche de la couche centrale qui est encadrée par des couches de nature, diélectrique ou métallique, différente de la sienne ou d'indices de réfraction différents du sien, l'épaisseur de la couche est uniforme perpendiculairement à ses surfaces de contact avec les couches adjacentes. Cette uniformité de l'épaisseur peut être globale sur toute l'étendue de la texture, ou locale sur des tronçons de la texture. En particulier, lorsque la texture présente des variations de pente, l'épaisseur entre deux surfaces de contact texturées consécutives peut changer, par tronçon, en fonction de la pente de la texture, les surfaces de contact texturées restant toutefois toujours parallèles entre elles. Ce cas se présente notamment pour une couche déposée par pulvérisation cathodique, où l'épaisseur de la couche est d'autant plus faible que la pente de la texture augmente. Ainsi, localement, sur chaque tronçon de texture ayant une pente donnée, l'épaisseur de la couche reste constante, mais l'épaisseur de la couche est différente entre un premier tronçon de texture ayant une première pente et un deuxième tronçon de texture ayant une deuxième pente différente de la première pente.

De manière avantageuse, afin d'obtenir le parallélisme des surfaces de contact texturées à l'intérieur de l'élément en couches, la ou chaque couche constitutive de la couche centrale est une couche déposée par pulvérisation cathodique. En effet, la pulvérisation cathodique, en particulier la pulvérisation cathodique assistée par un champ magnétique, garantit que les surfaces délimitant la couche sont parallèles entre elles, ce qui n'est pas le cas d'autres techniques de dépôt telles que l'évaporation ou le dépôt chimique en phase vapeur (CVD), ou encore le procédé sol-gel. Or, le parallélisme des surfaces de contact texturées à l'intérieur de l'élément en couches est essentiel pour obtenir une transmission spéculaire à travers l'élément.

Dans un mode de réalisation avantageux, le rapport de la transmission de l'élément en couches dans ledit domaine de longueurs d'onde donné sur la réflexion totale de l'élément en couches du côté de la deuxième couche externe dans ledit domaine de longueurs d'onde donné est supérieur ou égal à 1,5, de préférence supérieur ou égal à 2.

La transmission d'un élément en couches dans un domaine de longueurs d'onde donné, exprimée en %, est mesurée en positionnant la source de rayonnement de telle sorte que le rayonnement est en incidence normale sur l'élément en couches. Il est indifférent que le rayonnement traverse l'élément en couches en allant de la première couche externe vers la deuxième couche externe ou en allant de la deuxième couche externe vers la première couche externe.

Selon un aspect de l'invention, le rapport de la transmission lumineuse de l'élément en couches sur la réflexion lumineuse totale de l'élément en couches du côté de la deuxième couche externe est supérieur ou égal à 1,5, de préférence supérieur ou égal à 2.

Dans le cadre de l'invention, la transmission lumineuse d'un élément en couches, exprimée en %, est mesurée selon la norme ISO 9050:2003 (illuminant D65 ; 2° Observateur), en positionnant la source lumineuse de telle sorte que le rayonnement est en incidence normale sur l'élément en couches.

Dans le mode de réalisation ci-dessus, on privilégie la transmission de rayonnement à travers l'élément en couches par rapport à la réflexion d'un rayonnement incident sur l'élément en couches du côté de la deuxième couche externe. Ainsi, même si l'intensité lumineuse est sensiblement la même des deux côtés de l'élément en couches, voire même si l'intensité lumineuse est légèrement plus forte du côté de la deuxième couche externe, un observateur placé du côté de la deuxième couche externe reçoit majoritairement de la lumière provenant du côté de la première couche externe, qui est transmise de manière spéculaire à travers l'élément, et seulement minoritairement de la lumière provenant du côté de la deuxième couche externe, qui est réfléchie sur l'élément. Cela contribue à réduire l'impression de flou ou de "vitrage sale" et ainsi à améliorer la netteté de la vision à travers l'élément en couches.

Selon un aspect de l'invention, l'élément en couches comprend au moins un élément absorbant dans le domaine de longueurs d'onde du visible, soit en tant que deuxième couche externe, soit en tant que couche additionnelle disposée du côté de la deuxième couche externe. Dans le cas d'une couche additionnelle disposée du côté de la deuxième couche externe et constituée en un matériau métallique ou en un matériau diélectrique ayant un indice de réfraction différent de celui des couches externes, la surface principale externe de la couche additionnelle doit être lisse, afin de maintenir une transmission spéculaire de rayonnement à travers l'élément en couches.

De préférence, l'élément absorbant a une transmission lumineuse comprise entre 10% et 60%. Dans le cadre de l'invention, la transmission lumineuse d'un élément, exprimée en %, est mesurée selon la norme ISO 9050:2003 (illuminant D65 ; 2° Observateur).

Dans un mode de réalisation, l'élément absorbant est un substrat rigide ou flexible, notamment en verre ou en matériau organique polymérique, qui est teinté dans la masse, par des colorants appropriés. Il peut s'agir, en particulier, d'un substrat en verre teinté tel que ceux commercialisés par Saint-Gobain Glass dans la gamme SGG PARSOL® ou par Saint-Gobain Sekurit dans la gamme SGS THERMOCONTROL® Venus, qui ont une transmission lumineuse comprise entre 10% et 60%, pour une épaisseur de l'ordre de 1 mm à 8 mm, notamment de 1,5 mm à 6 mm. Il peut s'agir par ailleurs d'un substrat polymérique teinté, notamment à base de polyesters tels que le polyéthylène téréphtalate (PET), le polybutylène téréphtalate (PBT), le polyéthylène naphtalate (PEN) ; de polyacrylates tels que le polyméthacrylate de méthyle (PMMA) ; de polycarbonates ; de polyuréthanes ; de polyamides ; de polyimides ; de polymères fluorés tels que l'éthylène tétrafluoroéthylène (ETFE), le polyfluorure de vinylidène (PVDF), le polychlorotrifluoréthylène (PCTFE), l'éthylène de chlorotrifluoréthylène (ECTFE), les copolymères éthylène-propylène fluorés (FEP) ; de résines photoréticulables et/ou photopolymérisables, telles que les résines thiolène, polyuréthane, uréthane-acrylate, polyester-acrylate ; de polythiouréthanes.

Dans un autre mode de réalisation, l'élément absorbant est un feuillet intercalaire en matériau organique polymérique, notamment thermoformable ou sensible à la pression, c'est-à-dire le type de feuillet qu'on utilise comme intercalaire dans les vitrages feuilletés, qui est teinté dans la masse, par des colorants appropriés. Il peut s'agir, en particulier, d'au moins un feuillet à base de polybutyral de vinyle (PVB), d'éthylène-acétate de vinyle (EVA), de polyuréthane (PU), de polyéthylène téréphtalate (PET), de polychlorure de vinyle (PVC). Ces feuillets intercalaires polymériques teintés présentent par exemple une transmission lumineuse comprise entre 25% et 60%, notamment entre 30% et 45%, pour une épaisseur de l'ordre de 0,2 mm à 0,8 mm, généralement aux environs de 0,38 mm. Dans une configuration avantageuse, le feuillet intercalaire teinté est feuilleté ou calandré à un substrat, par exemple un verre clair ou extra-clair clair.

Dans encore un autre mode de réalisation, l'élément absorbant est une couche mince absorbante dans le domaine de longueurs d'onde du visible, disposée sur une face d'un substrat rigide ou flexible, notamment en verre ou en matériau organique polymérique, ou sur une face d'un feuillet intercalaire polymérique. On entend par couche mince une couche d'épaisseur inférieure à 10 $\mu$m, de préférence inférieure à 1 $\mu$m. Il peut également s'agir d'un empilement de couches minces, dont l'une au moins est absorbante dans le domaine de longueurs d'onde du visible. Il peut par exemple s'agir de couches à base d'oxyde de nickel et/ou de fer et/ou de chrome, qui peuvent être déposées par une technique de décomposition thermique, notamment par pyrolyse en phase gazeuse, sous forme de poudre ou en phase liquide ; par une technique sous vide, en particulier par pulvérisation cathodique, notamment assistée par champ magnétique ; ou encore par un procédé sol-gel.

Selon un aspect de l'invention, la couche centrale de l'élément en couches comprend au moins une couche mince constituée en un matériau diélectrique à haut indice de réfraction, différent de l'indice de réfraction des couches externes, tel que $Si_3N_4$, $SnO_2$, ZnO, AlN, NbO, NbN, $TiO_2$, ou constituée en un matériau diélectrique à bas indice de réfraction, différent de l'indice de réfraction des couches externes, tel que $SiO_2$, $Al_2O_3$, $MgF_2$, $AlF_3$. La couche centrale de l'élément en couches peut également comprendre au moins une couche mince métallique, notamment une couche mince d'argent, d'or, de titane, de niobium, de silicium, d'aluminium, d'alliage nickel-chrome (NiCr), d'acier inoxydable, ou de leurs alliages.

De manière avantageuse, la composition de la couche centrale de l'élément en couches peut être ajustée pour conférer des propriétés supplémentaires à l'élément en couches, par exemple des propriétés thermiques, de type contrôle solaire et/ou basse émissivité. Ainsi, dans un mode de réalisation, la couche centrale de l'élément en couches est un empilement de couches minces comprenant une alternance de « n » couches fonctionnelles métalliques, notamment de couches fonctionnelles à base d'argent ou d'alliage métallique contenant de l'argent, et de « (n + 1) » revêtements antireflet, avec n ≥ 1, où chaque couche fonctionnelle métallique est disposée entre deux revêtements antireflet.

De manière connue, un tel empilement à couche fonctionnelle métallique présente des propriétés de réflexion dans le domaine du rayonnement solaire et/ou dans le domaine du rayonnement infrarouge de grande longueur d'onde. Dans un tel empilement, la ou les couches fonctionnelles métalliques déterminent essentiellement les performances thermiques, tandis que les revêtements antireflet qui les encadrent agissent sur l'aspect optique de manière interférentielle. En effet, si les couches fonctionnelles métalliques permettent d'obtenir des performances thermiques souhaitées même à une faible épaisseur géométrique, de l'ordre de 10 nm pour chaque couche fonctionnelle métallique, elles s'opposent toutefois fortement au passage de rayonnement dans le domaine de longueurs d'onde du visible. Dès lors, des revêtements antireflet de part et d'autre de chaque couche fonctionnelle métallique sont nécessaires pour assurer une bonne transmission lumineuse dans le domaine du visible. En pratique, c'est l'empilement global de la couche centrale, comprenant les couches minces métalliques et les revêtements antireflet, qui est optimisé optiquement. De manière avantageuse, l'optimisation optique peut être faite sur l'empilement global de l'élément en couches, c'est-à-dire incluant les couches externes positionnées de part et d'autre de la couche centrale et les éventuelles couches additionnelles.

L'élément en couches obtenu combine alors des propriétés optiques, à savoir des propriétés de transmission spéculaire et de réflexion diffuse d'un rayonnement incident sur l'élément en couches, et des propriétés thermiques, à savoir des propriétés de contrôle solaire et/ou de basse émissivité. Un tel élément en couches peut être utilisé pour des vitrages de protection solaire et/ou d'isolation thermique, notamment de véhicules ou de bâtiments.

Selon un aspect de l'invention, la couche centrale de l'élément en couches est un empilement asymétrique de couches minces, le rapport de la réflexion totale de la couche centrale du côté tourné vers la première couche externe dans ledit domaine de longueurs d'onde donné sur la réflexion totale de la couche centrale du côté tourné vers la deuxième couche externe dans ledit domaine de longueurs d'onde donné étant supérieur ou égal à 1,5, de préférence supérieur ou égal à 2.

Selon un aspect de l'invention, le rapport de la réflexion lumineuse totale de la couche centrale du côté tourné vers la première couche externe sur la réflexion lumineuse totale de la couche centrale du côté tourné vers la deuxième couche externe est supérieur ou égal à 1,5, de préférence supérieur ou égal à 2.

De manière avantageuse, l'élément en couches comprend, sur sa surface principale externe située du côté de la première couche externe et/ou sur sa surface principale externe située du côté de la deuxième couche externe, un revêtement antireflet à l'interface entre l'air et le matériau constitutif de la couche formant la surface principale externe.

Un revêtement antireflet sur la surface principale externe de l'élément en couches située du côté de la deuxième couche externe permet de limiter la réflexion spéculaire de rayonnement sur cette surface principale externe. Il en résulte une diminution de la réflexion totale de rayonnement du côté de la deuxième couche externe, ce qui contribue à réduire l'impression de flou ou de "vitrage sale" et ainsi à améliorer la netteté de la vision à travers l'élément en couches pour un observateur placé du côté de la deuxième couche externe.

Par ailleurs, lorsqu'un revêtement antireflet est présent sur la surface principale externe de l'élément en couches située du côté de la première couche externe, un rayonnement incident sur l'élément en couches du côté de la première couche externe est réfléchi de manière privilégiée à chaque surface de contact texturée plutôt que sur la surface principale externe lisse de l'élément en couches, ce qui correspond à un mode de réflexion diffuse plutôt qu'à un mode de réflexion spéculaire. Une réflexion diffuse du rayonnement par l'élément en couches du côté de la première couche externe est ainsi favorisée par rapport à une réflexion spéculaire.

Le revêtement antireflet prévu sur au moins l'une des surfaces principales externes de l'élément en couches peut être de tout type permettant de réduire la réflexion de rayonnement à l'interface entre l'air et la couche formant la surface principale externe de l'élément en couches. Il peut s'agir, notamment, d'une couche d'indice de réfraction compris entre l'indice de réfraction de l'air et l'indice de réfraction de la couche formant la surface principale externe, telle qu'une couche déposée sur la surface de la couche formant la surface principale externe par une technique sous vide ou une couche poreuse de type sol-gel, ou encore, dans le cas où la couche formant la surface principale externe est en verre, une partie superficielle creusée de cette couche en verre obtenue par un traitement à l'acide de type "etching". En variante, le revêtement antireflet peut être formé par un empilement de couches minces ayant des indices de réfraction alternativement plus faibles et plus forts jouant le rôle d'un filtre interférentiel à l'interface entre l'air et la couche formant la surface principale externe, ou par un empilement de couches minces présentant un gradient, continu ou échelonné, d'indices de réfraction entre l'indice de réfraction de l'air et celui de la couche formant la surface principale externe.

Les surfaces principales externes lisses de l'élément en couches peuvent être planes ou bombées. En particulier, l'élément en couches peut être un vitrage bombé, par exemple pour des bâtiments ou des véhicules, notamment automobiles. De préférence, les surfaces principales externes lisses de l'élément en couches sont parallèles entre elles. Cela contribue à limiter la dispersion lumineuse pour un rayonnement traversant l'élément en couches, et donc à améliorer la netteté de la vision à travers l'élément en couches.

Selon un aspect de l'invention, la texture de chaque surface de contact entre deux couches adjacentes de l'élément en couches qui sont l'une en matériau métallique et l'autre en matériau diélectrique, ou qui sont deux couches en matériaux diélectriques d'indices de réfraction différents, est formée par une pluralité de motifs en creux ou en saillie par rapport à un plan général de la surface de contact. De préférence, la hauteur moyenne des motifs de chaque surface de contact entre deux couches adjacentes de l'élément en couches qui sont l'une en matériau métallique et l'autre en matériau diélectrique, ou qui sont deux couches en matériaux diélectriques d'indices de réfraction différents, est comprise entre 1 $\mu$m et 2 mm et mieux entre 2 $\mu$m et 200 $\mu$m, encore mieux entre 5 $\mu$m et 100 $\mu$m. Au sens de l'invention, la hauteur moyenne des motifs de la surface de contact est définie comme la moyenne arithmétique des distances $y_i$ en valeur absolue prises entre le sommet et le plan général de la surface de contact pour chaque motif de la surface de contact, égale à $\frac{1}{n}\sum_{i=1}^{n}\left|y_i\right|,$ ce qui correspond à l'écart moyen arithmétique Ra.

Les motifs de la texture de chaque surface de contact entre deux couches adjacentes de l'élément en couches qui sont l'une en matériau métallique et l'autre en matériau diélectrique, ou qui sont deux couches en matériaux diélectriques d'indices de réfraction différents, peuvent être répartis de manière aléatoire sur la surface de contact. En variante, les motifs de la texture de chaque surface de contact entre deux couches adjacentes de l'élément en couches qui sont l'une en matériau métallique et l'autre en matériau diélectrique, ou qui sont deux couches en matériaux diélectriques d'indices de réfraction différents, peuvent être répartis de manière périodique sur la surface de contact. Ces motifs peuvent être, notamment, des cônes, des pyramides, des rainures, des nervures, des vaguelettes.

Les motifs peuvent également n'être présents que dans certaines zones de chaque surface de contact, ces zones texturées pouvant être séparées par des zones non texturées de chaque surface de contact. Dans ce cas, comme une caractéristique de l'élément en couches selon l'invention est que toutes les surfaces de contact entre deux couches adjacentes de l'élément en couches qui sont de natures différentes ou d'indices de réfraction différents sont texturées et parallèles entre elles, on obtient un vitrage ou un film qui ne comprend l'élément en couches selon l'invention que dans certaines zones, correspondant aux zones texturées de chaque surface de contact. Il en résulte une réflexion diffuse de rayonnement seulement dans certaines zones du vitrage ou du film, correspondant aux zones texturées de chaque surface de contact. Des variations spatiales du niveau de réflexion diffuse peuvent également être obtenues selon le même principe, en modulant spatialement les propriétés de la texture de chaque surface de contact. Il est ainsi possible, par exemple, d'afficher un dessin ou un logo par réflexion diffuse de la lumière visible d'un côté du vitrage ou du film, qui est situé du côté de la première couche externe de l'élément en couches, ce dessin ou logo étant invisible du côté opposé du vitrage ou du film, qui est situé du côté de la deuxième couche externe de l'élément en couches.

Une texturation de seulement certaines zones de chaque surface de contact peut être réalisée en pratique en déposant la ou chaque couche de la couche centrale de manière conforme sur un substrat présentant une texturation partielle. Une texturation partielle d'un substrat peut être obtenue par tout procédé connu de texturation, par exemple par embossage de la surface du substrat, par abrasion, par sablage, par traitement chimique ou par gravure, en utilisant par exemple des masques pour conserver au moins une partie de la surface du substrat non texturée.

Selon un aspect de l'invention, pour chaque couche de la couche centrale qui est encadrée par des couches de nature, métallique ou diélectrique, différente de la sienne ou d'indices de réfraction différents du sien, l'épaisseur de cette couche, prise perpendiculairement à ses surfaces de contact avec les couches adjacentes, est faible par rapport à la hauteur moyenne des motifs de chacune de ses surfaces de contact avec les couches adjacentes. Une telle épaisseur faible permet d'augmenter la probabilité que l'interface d'entrée d'un rayonnement dans cette couche et l'interface de sortie du rayonnement hors de cette couche soient parallèles, et donc d'augmenter le pourcentage de transmission spéculaire du rayonnement à travers l'élément en couches. De manière avantageuse, l'épaisseur de chaque couche de la couche centrale qui est intercalée entre deux couches de nature, métallique ou diélectrique, différente de la sienne ou d'indices de réfraction différents du sien, où cette épaisseur est prise perpendiculairement à ses surfaces de contact avec les couches adjacentes, est inférieure à 1/4 de la hauteur moyenne des motifs de chacune de ses surfaces de contact avec les couches adjacentes. En pratique, lorsque la couche centrale est une couche mince ou un empilement de couches minces, l'épaisseur de la ou chaque couche de la couche centrale est de l'ordre de, ou inférieure à, 1/10 de la hauteur moyenne des motifs de chaque surface de contact texturée de l'élément en couches.

Dans un mode de réalisation de l'invention, l'une des deux couches externes de l'élément en couches est une couche externe texturée comprenant un substrat rigide ou flexible, notamment en verre ou en matériau organique polymérique, dont une surface principale est texturée. La texturation de l'une des surfaces principales du substrat peut être obtenue par tout procédé connu de texturation, par exemple par embossage de la surface du substrat préalablement chauffée à une température à laquelle il est possible de la déformer, en particulier par laminage au moyen d'un rouleau ayant à sa surface une texturation complémentaire de la texturation à former sur le substrat ; par abrasion au moyen de particules ou de surfaces abrasives, en particulier par sablage ; par traitement chimique, notamment traitement à l'acide dans le cas d'un substrat en verre ; par moulage, notamment moulage par injection dans le cas d'un substrat en polymère thermoplastique ; par gravure.

Des exemples de substrats texturés en verre directement utilisables en tant que couche externe texturée de l'élément en couches comprennent :

- les substrats en verre commercialisés par Saint-Gobain Glass dans la gamme SGG SATINOVO®, qui présentent sur l'une de leurs surfaces principales une texture obtenue par sablage ou attaque acide ;
- les substrats en verre commercialisés par Saint-Gobain Glass dans la gamme SGG ALBARINO® S, P ou G ou dans la gamme SGG MASTERGLASS®, qui présentent sur l'une de leurs surfaces principales une texture obtenue par laminage ;
- les substrats en verre à haut indice texturés par sablage tel que du verre flint par exemple commercialisés par Schott sous les références SF6 (n=1,81 à 550 nm), 7SF57 (n=1,85 à 550 nm), N-SF66 (n=1,92 à 550 nm), P-SF68 (n=2,00 à 550 nm).

Dans le cas d'une couche externe texturée formée par un substrat texturé en matériau organique polymérique, des exemples de matériaux appropriés comprennent, notamment, les polyesters tels que le polyéthylène téréphtalate (PET), le polybutylène téréphtalate (PBT), le polyéthylène naphtalate (PEN) ; les polyacrylates tels que le polyméthacrylate de méthyle (PMMA) ; les polycarbonates ; les polyuréthanes ; les polyamides ; les polyimides ; les polymères fluorés tels que l'éthylène tétrafluoroéthylène (ETFE), le polyfluorure de vinylidène (PVDF), le polychlorotrifluoréthylène (PCTFE), l'éthylène de chlorotrifluoréthylène (ECTFE), les copolymères éthylène-propylène fluorés (FEP) ; les résines photoréticulables et/ou photopolymérisables, telles que les résines thiolène, polyuréthane, uréthane-acrylate, polyester-acrylate ; les polythiouréthanes. Ces polymères présentent en général une gamme d'indice de réfraction à 550 nm allant de 1,30 à 1,70. Toutefois, il est intéressant de noter que certains de ces polymères, et notamment les polymères comprenant du soufre tels que les polythiouréthanes, peuvent présenter des indices de réfraction à 550 nm élevés pouvant aller jusqu'à 1,74.

Lorsque c'est la deuxième couche externe qui comprend un substrat texturé, ce substrat texturé peut être teinté dans la masse de manière à constituer un élément absorbant, ou être revêtu d'une couche mince absorbante, comme décrit précédemment.

Dans un autre mode de réalisation de l'invention, l'une des deux couches externes de l'élément en couches est une couche externe texturée formée par une couche conformable, dont une surface principale est texturée et qui est rapportée par son autre surface principale sur un substrat rigide ou flexible. Il peut s'agir notamment d'une couche thermoformable ou d'une couche en matériau photoréticulable et/ou photopolymérisable. Dans ce cas, un procédé bien approprié pour la texturation de l'une des surfaces principales de la couche conformable est, notamment, l'embossage. De préférence, le matériau photoréticulable et/ou photopolymérisable se présente sous forme liquide à température ambiante et donne, lorsqu'il a été irradié et photoréticulé et/ou photopolymérisé, un solide transparent dépourvu de bulles ou de toute autre irrégularité. Il peut s'agir en particulier d'une résine telle que celles habituellement utilisées comme adhésifs, colles ou revêtements de surface. Ces résines sont généralement à base de monomères/ comonomères/pré-polymères de type époxy, époxysilane, acrylate, méthacrylate, acide acrylique, acide méthacrylique. On peut citer par exemple les résines thiolène, polyuréthane, uréthane-acrylate, polyester-acrylate. Au lieu d'une résine, il peut s'agir d'un gel aqueux photoréticulable, tel qu'un gel de polyacrylamide.

Lorsque l'une des deux couches externes de l'élément en couches est une couche externe texturée ayant une surface principale texturée et son autre surface principale lisse, la couche centrale est avantageusement formée :

- soit par une couche unique en matériau métallique, ou en matériau diélectrique d'indice de réfraction différent de celui de la couche externe texturée, déposée de manière conforme sur la surface principale texturée de la couche externe texturée,
- soit par un empilement de couches, qui comprend au moins une couche en matériau métallique ou en matériau diélectrique d'indice de réfraction différent de celui de la couche externe texturée, déposées successivement de manière conforme sur la surface principale texturée de la couche externe texturée.

Selon l'invention, on considère que le dépôt de la couche centrale, ou le dépôt successif des couches de la couche centrale, sur la surface principale texturée de la couche externe texturée est réalisé de manière conforme si, suite au dépôt, la surface de la ou chaque couche de la couche centrale est texturée et parallèle à la surface principale texturée de la couche externe texturée. Selon une caractéristique avantageuse, le dépôt de la couche centrale de manière conforme, ou des couches de la couche centrale successivement de manière conforme, sur la surface principale texturée de la couche externe texturée est réalisé par pulvérisation cathodique, notamment assistée par un champ magnétique. D'autres techniques de dépôt conforme sont également envisageables, telles que des techniques d'évaporation, en particulier pour le dépôt de couches métalliques.

Selon un aspect de l'invention, l'autre couche externe de l'élément en couches, c'est-à-dire la couche externe située de l'autre côté de la couche centrale par rapport à la couche externe texturée, comprend une couche de matériau durcissable d'indice de réfraction sensiblement égal à celui de la couche externe texturée, déposée sur la surface principale texturée de la couche centrale opposée à la couche externe texturée en étant initialement dans un état visqueux, liquide ou pâteux adapté à des opérations de mise en forme.

La couche déposée initialement dans un état visqueux, liquide ou pâteux peut être, en particulier, une couche de type vernis, qui assure alors une planarisation de la surface de l'élément en couches. En variante, la couche déposée initialement dans un état visqueux, liquide ou pâteux peut être une couche assurant une solidarisation entre, d'une part, la couche externe texturée munie de la couche centrale et, d'autre part, un contre-substrat.

La couche déposée initialement dans un état visqueux, liquide ou pâteux peut être une couche de matériau photoréticulable et/ou photopolymérisable. De préférence, ce matériau photoréticulable et/ou photopolymérisable se présente sous forme liquide à température ambiante et donne, lorsqu'il a été irradié et photoréticulé et/ou photopolymérisé, un solide transparent dépourvu de bulles ou de toute autre irrégularité. Il peut s'agir en particulier d'une résine telle que celles habituellement utilisées comme adhésifs, colles ou revêtements de surface. Ces résines sont généralement à base de monomères/ comonomères/pré-polymères de type époxy, époxysilane, acrylate, méthacrylate, acide acrylique, acide méthacrylique. On peut citer par exemple les résines thiolène, polyuréthane, uréthane-acrylate, polyester-acrylate. Au lieu d'une résine, il peut s'agir d'un gel aqueux photoréticulable, tel qu'un gel de polyacrylamide.

En variante, la couche déposée initialement dans un état visqueux, liquide ou pâteux peut être une couche déposée par un procédé sol-gel.

Dans un mode de réalisation, l'autre couche externe de l'élément en couches, c'est-à-dire la couche externe située de l'autre côté de la couche centrale par rapport à la couche externe texturée, comprend une couche sol-gel comprenant une matrice hybride organique/inorganique à base de silice. Une telle couche sol-gel est particulièrement avantageuse car elle offre la possibilité d'ajuster avec précision la valeur de son indice de réfraction, de sorte qu'il soit le plus proche possible de celui de la couche externe texturée. Selon l'invention, l'accord d'indice ou écart d'indice entre les deux couches externes de l'élément en couches correspond à la valeur absolue de la différence entre les indices de réfraction à 550 nm de leurs matériaux diélectriques constitutifs. Plus l'écart d'indice est faible, plus la vision à travers l'élément en couches est nette. En particulier, on obtient une excellente vision avec un accord d'indice inférieur ou égal à 0,050, de préférence inférieur ou égal à 0,030 et mieux inférieur ou égal à 0,015.

Le procédé sol-gel consiste, dans un premier temps, à préparer une solution dite "solution sol-gel" contenant des précurseurs qui donnent lieu en présence d'eau à des réactions de polymérisation. Lorsque cette solution sol-gel est déposée sur une surface, du fait de la présence d'eau dans la solution sol-gel ou au contact de l'humidité ambiante, les précurseurs s'hydrolysent et se condensent pour former un réseau emprisonnant le solvant. Ces réactions de polymérisation entraînent la formation d'espèces de plus en plus condensées, qui conduisent à des particules colloïdales formant des sols puis des gels. Le séchage et la densification de ces gels, à une température de l'ordre de quelques centaines de degrés, conduit, en présence de précurseur à base de silice, à une couche sol-gel correspondant à un verre dont les caractéristiques sont semblables à celles d'un verre classique.

Du fait de leur viscosité, les solutions sol-gel, sous forme d'une solution colloïdale ou d'un gel, peuvent être déposées de manière aisée sur la surface principale texturée de la couche centrale opposée à la couche externe texturée, en se conformant à la texture de cette surface. La couche sol-gel va venir "combler" la rugosité de la couche centrale. En effet, cette couche comprend une surface épousant la rugosité de surface de la couche centrale qui est ainsi texturée et une surface principale externe opposée à cette surface qui est plane. Les couches déposées par un procédé sol-gel assurent donc une planarisation de la surface de l'élément en couches.

La matrice hybride organique/inorganique à base de silice de la couche sol-gel est obtenue à partir de précurseurs mixtes qui sont des organosilanes $R_nSiX_{(4-n)}$. Ces molécules comportent simultanément des fonctions hydrolysables qui donnent naissance à un réseau ou matrice de silice comprenant des fonctions organiques qui restent fixées sur le squelette de silice.

Selon un mode de réalisation, la couche sol-gel comprend en outre des particules d'au moins un oxyde métallique ou d'au moins un chalcogénure.

Selon un mode de réalisation, la matrice hybride organique/inorganique à base de silice comprend en outre au moins un oxyde métallique. Une telle matrice à base de silice comprenant des fonctions organiques et au moins un oxyde métallique peut être obtenue à partir de l'utilisation conjointe d'organosilane et d'au moins un précurseur d'un oxyde métallique. Ces précurseurs forment alors avec l'organosilane une matrice hybride de silice et d'oxyde métallique.

Dans un mode de réalisation préféré, la couche sol-gel comprend une matrice hybride organique/inorganique à base de silice et d'au moins un oxyde métallique dans laquelle sont dispersées des particules d'au moins un oxyde métallique ou d'au moins un chalcogénure telle qu'une matrice hybride organique/inorganique de silice et d'oxyde de zirconium dans laquelle sont dispersées des particules de dioxyde de titane.

Les composés principaux de la couche sol-gel sont constitués des composés formant la matrice et des particules dispersées dans ladite matrice. Les composés principaux de la couche sol-gel peuvent donc être : la silice comprenant des fonctions organiques de la matrice ; le ou les oxydes métalliques de la matrice ; les particules d'oxydes métalliques et/ou de chalcogénures dispersées dans la matrice. Pour adapter avec précision l'indice de réfraction de la couche sol-gel, on modifie les proportions d'oxydes métalliques provenant de la matrice ou dispersées sous forme de particules. En règle générale, les oxydes métalliques ont un indice de réfraction plus élevé que celui de la silice. En augmentant les proportions d'oxyde métallique, on augmente l'indice de réfraction de la couche sol-gel. L'indice de réfraction de la couche sol-gel augmente de manière linéaire en fonction de la fraction volumique d'un type d'oxyde métallique pour des proportions en volume dudit oxyde métallique inférieures à une valeur seuil. Par exemple, lorsque l'on ajoute des particules de $TiO_2$, on observe une variation linéaire de l'indice de réfraction de la couche sol-gel pour des proportions en volume de $TiO_2$ par rapport au volume total des composés principaux de la couche sol-gel inférieures à 20%.

Il est donc possible de déterminer théoriquement l'indice de réfraction d'une couche sol-gel en fonction des composés principaux la constituant et ainsi de déterminer théoriquement la formulation d'une solution sol-gel qui permettra d'obtenir après durcissement une couche sol-gel présentant l'indice de réfraction requis. En particulier, il est possible d'ajuster la formulation de la solution sol-gel de manière à obtenir après durcissement une couche sol-gel présentant un accord d'indice de réfraction avec la couche externe texturée à 0,015 près, et ce dans une large gamme d'indice de réfraction puisque ces couches sol-gel peuvent avoir un indice de réfraction à 550 nm variant dans une gamme d'indice allant notamment de 1,459 à 1,700.

La couche sol-gel comprend de préférence en masse par rapport à la masse totale des composés principaux constituant la couche sol-gel :

- 50 à 100%, de préférence 70 à 95% et mieux 85 à 90% de silice comprenant des fonctions organiques de la matrice, et/ou
- 0 à 10%, de préférence 1 à 5% et mieux 2 à 4% d'oxyde métallique de la matrice, et/ou
- 0 à 40%, de préférence 1 à 20%, et mieux 5 à 15% de particules d'oxydes métalliques et/ou de chalcogénures dispersées dans la matrice.

La couche sol-gel est obtenue par durcissement d'une solution sol-gel et comprend le produit résultant de l'hydrolyse et de la condensation d'au moins un organosilane de formule générale $R_nSiX_{(4-n)}$ dans laquelle :

- n égal à 1, 2, 3, de préférence n égal à 1 ou 2 et mieux n égal à 1,
- les groupes X, identiques ou différents, représentent des groupes hydrolysables choisis parmi les groupe alcoxy, acyloxy ou halogénure, de préférence alcoxy, et
- les groupes R, identiques ou différents, représentent des groupes organiques (ou fonctions organiques) non hydrolysables liés au silicium par un atome de carbone.

De préférence, la couche sol-gel est obtenue par durcissement d'une solution sol-gel et comprend le produit résultant de l'hydrolyse et de la condensation de :

i) au moins un organosilane et

ii) au moins un précurseur d'un oxyde métallique et/ ou

iii) des particules d'au moins un oxyde métallique ou d'au moins un chalcogénure.

Les particules d'oxyde métallique et/ou les précurseurs des oxydes métalliques de la matrice hybride organique/inorganique comprennent un métal choisi parmi le titane, zirconium, le zinc, le niobium, l'aluminium et le molybdène.

Le ou les organosilanes comprennent deux ou trois, en particulier trois, groupes hydrolysables X, et un ou deux, en particulier un, groupe non hydrolysable R.

Les groupes X sont préférentiellement choisis parmi les groupes alcoxy - O-R', en particulier alcoxy en C1-C4, acyloxy -O-C(O)R' où R' est un radical alkyle, préférentiellement en C1-C6, de préférence méthyle ou éthyle, halogénure tels que Cl, Br et I, et les combinaisons de ces groupes. De préférence, les groupes X sont des groupes alcoxy, et en particulier méthoxy ou éthoxy.

Le groupe R est un groupe hydrocarboné non hydrolysable. Un certain nombre de groupes conviennent selon l'invention. La présence et la nature de ces groupes permet d'obtenir des couches sol-gel présentant des épaisseurs compatibles avec les applications de l'invention. De préférence, le groupe R correspondant à la fonction organique non hydrolysable présente une masse molaire d'au moins 50 g/mol, de préférence d'au moins 100 g/mol. Ce groupe R est donc un groupe non éliminable, même suite à l'étape de séchage et peut être choisi, notamment, parmi : les groupes alkyle, de préférence les groupes alkyle linéaires ou ramifiés en C1 à C10, tels que par exemple les groupes méthyle, éthyle, propyle, n- butyle, i-butyle, sec-butyle et tertiobutyle ; les groupes alcényle, de préférence les groupes alcényle en C2 à C10, tels que par exemple les groupes vinyle, 1- propényle, 2-propényle et butényle ; les groupes alcinyles tels que par exemple les groupes acétylényle et propargyle ; les groupes aryle, de préférence les groupes aryle en C6 à C10, tels que les groupes phényle et naphtyle ; les groupes alkyl-aryle ; les groupes aryl-alkyle ; les groupes (méth)acryle et (méth)acryloxy-propyle ; les groupes glycidyle et glycidyloxy. Un composé préféré pour le composé organosilane est, en particulier, le 3-glycidoxypropyltriméthoxysilane (GLYMO).

Les particules d'oxyde métallique et/ou de chalcogénure dispersées dans la matrice hybride organique/inorganique à base de silice sont de préférence des particules d'oxyde métallique comprenant un métal choisi parmi le titane, le zirconium, le zinc, le niobium, l'aluminium et le molybdène.

Les organosilanes (i), les précurseurs d'oxydes métalliques (ii) et les oxydes métalliques et chalcogénure (iii) sont les composés principaux de la solution sol-gel. La solution sol-gel peut comprendre, en plus des composés principaux, au moins un solvant et éventuellement au moins un additif.

Parmi les solvants appropriés, on peut citer l'eau, le méthanol, l'éthanol, le propanol (le n-propanol et l'isopropanol), le butanol, le 1-méthoxy-2-propanol, le 4-hydroxy-4-méthyl-2-pentanone, le 2-méthyl-2-butanol, le butoxyéthanol et les mélange eau/solvants organiques. Les proportions de solvant peuvent varier dans une large gamme. Elles dépendront notamment des épaisseurs à obtenir. En effet, plus la solution sol-gel présente un contenu solide élevé, plus il est possible de déposer des épaisseurs importantes et donc d'obtenir des couches sol-gel d'épaisseurs élevées.

Les additifs peuvent être des agents tensioactifs, des absorbeurs UV, des catalyseurs d'hydrolyse et/ou de condensation, des catalyseurs de durcissement.

La solution sol-gel peut également comprendre en tant qu'additifs des colorants, ce qui est particulièrement avantageux dans le cas où c'est la deuxième couche externe qui comprend la couche sol-gel, car cette dernière constitue alors un élément absorbant tel que décrit précédemment. On peut en particulier introduire dans la matrice de particules colloïdales des oxydes métalliques colorés tels que des particules d'oxyde de cobalt, de vanadium, de chrome, de manganèse, de fer, de nickel, de cuivre et de tous autres métaux de transition et de non métaux susceptibles de jouer le rôle de colorant.

Les proportions totales des additifs représentent de préférence moins de 5% en masse par rapport à la masse totale de la solution sol-gel.

Le dépôt de la couche sol-gel peut se faire selon toute technique connue appropriée, notamment par trempage-retrait ("dip-coating") ; enduction centrifuge ("spin-coating") ; enduction laminaire ("laminar-flow-coating" ou "meniscus-coating") ; pulvérisation ("spray-coating") ; épandage ("soak-coating") ; enduction au rouleau ("roll-process") ; enduction au pinceau ("paint-coating") ; sérigraphie ("screen-printing"). De préférence, le dépôt de la couche sol-gel est effectué par pulvérisation avec atomisation pneumatique. La température de séchage du film sol-gel peut varier de 0 à 200°C, de préférence de 100°C à 150°C, de préférence encore de 120 à 170°C.

Selon un aspect de l'invention, l'autre couche externe de l'élément en couches, c'est-à-dire la couche externe située de l'autre côté de la couche centrale par rapport à la couche externe texturée, comprend au moins un feuillet intercalaire en matériau organique polymérique, notamment thermoformable ou sensible à la pression, d'indice de réfraction sensiblement égal à celui de la couche externe texturée, qui est positionné contre la surface principale texturée de la couche centrale opposée à la couche externe texturée et mis en forme contre cette surface texturée par chauffage et/ou compression. Il peut s'agir, en particulier, d'au moins un feuillet à base de polybutyral de vinyle (PVB), d'éthylène-acétate de vinyle (EVA), de polyuréthane (PU), de polyéthylène téréphtalate (PET), de polychlorure de vinyle (PVC).

Ce feuillet intercalaire peut être feuilleté ou calandré à un substrat, notamment un substrat en verre.

L'élément en couches peut être un vitrage. Il peut s'agir d'un vitrage plan ou bombé.

En variante, l'élément en couches peut être un film flexible. Un tel film flexible est avantageusement muni, sur l'une de ses surfaces principales externes, d'une couche d'adhésif recouverte d'une bande de protection destinée à être retirée pour le collage du film. L'élément en couches sous forme de film flexible est alors apte à être rapporté par collage sur une surface existante, par exemple une surface d'un vitrage, afin de conférer à cette surface des propriétés de réflexion diffuse, tout en maintenant des propriétés de transmission spéculaire et un haut niveau de netteté de vision à travers le vitrage même lorsque le contraste lumineux entre les deux côtés du vitrage est relativement faible. Le vitrage sur lequel est rapporté l'élément en couches sous forme de film flexible peut être un vitrage plan ou bombé.

L'invention a ainsi pour objet un vitrage de véhicule, bâtiment, mobilier urbain, ameublement intérieur, dispositif d'éclairage, support d'affichage, écran de projection, comprenant au moins un élément en couches tel que décrit précédemment.

L'invention a également pour objet l'utilisation d'un élément en couches tel que décrit précédemment comme tout ou partie d'un vitrage pour véhicule, bâtiment, mobilier urbain, ameublement intérieur, dispositif d'éclairage, support d'affichage, écran de projection.

Dans le cas d'un vitrage de véhicule, l'invention est particulièrement avantageuse pour les vitrages de toit, vitrages latéraux, vitrages de lunette arrière.

Un élément en couches selon l'invention peut avoir diverses fonctions lorsqu'il agit dans le domaine de longueurs d'onde du visible, en diffusant la lumière visible incidente du côté de la première couche externe tout en permettant une vision nette lorsqu'il est regardé du côté de la deuxième couche externe, par exemple une fonction décorative ou esthétique ; une fonction de "privacy" pour procurer une intimité ; une fonction d'affichage à des fins de communication ou de publicité, notamment par la mise en place de dessins ou de logos comme décrit précédemment ; une fonction pour la projection d'images, où l'on peut projeter des images d'un premier côté d'un vitrage ou d'un film comprenant l'élément en couches, correspondant au côté de la première couche externe, avec le projecteur et l'utilisateur situés tous les deux de ce premier côté, tout en gardant une bonne vision à travers le vitrage ou le film pour un observateur situé du côté opposé au premier côté, correspondant au côté de la deuxième couche externe. Un élément en couches selon l'invention peut avoir également d'autres fonctions lorsqu'il agit dans d'autres domaines de longueurs d'onde, par exemple une fonction de diffusion du rayonnement infrarouge incident du côté de la première couche externe.

Les caractéristiques et avantages de l'invention apparaîtront dans la description qui va suivre de plusieurs modes de réalisation d'un élément en couches, donnée uniquement à titre d'exemple et faite en se référant aux dessins annexés dans lesquels :

- la figure 1 est une coupe transversale schématique d'un élément en couches conforme à un premier mode de réalisation de l'invention ;
- la figure 2 est une vue à plus grande échelle du détail I de la figure 1 pour une première variante de l'élément en couches ;
- la figure 3 est une vue à plus grande échelle du détail I de la figure 1 pour une deuxième variante de l'élément en couches ;
- la figure 4 est un schéma montrant des étapes d'un procédé de fabrication de l'élément en couches de la figure 1 ;
- la figure 5 est une coupe analogue à la figure 1 pour un élément en couches conforme à un deuxième mode de réalisation de l'invention ;
- la figure 6 est une coupe analogue à la figure 1 pour un élément en couches conforme à un troisième mode de réalisation de l'invention ;
- la figure 7 est une coupe analogue à la figure 1 pour un élément en couches conforme à un quatrième mode de réalisation de l'invention ;
- la figure 8 est un schéma montrant des étapes d'un procédé de fabrication de l'élément en couches de la figure 7 ; et
- la figure 9 est une coupe analogue à la figure 1 pour un élément en couches conforme à un cinquième mode de réalisation de l'invention.

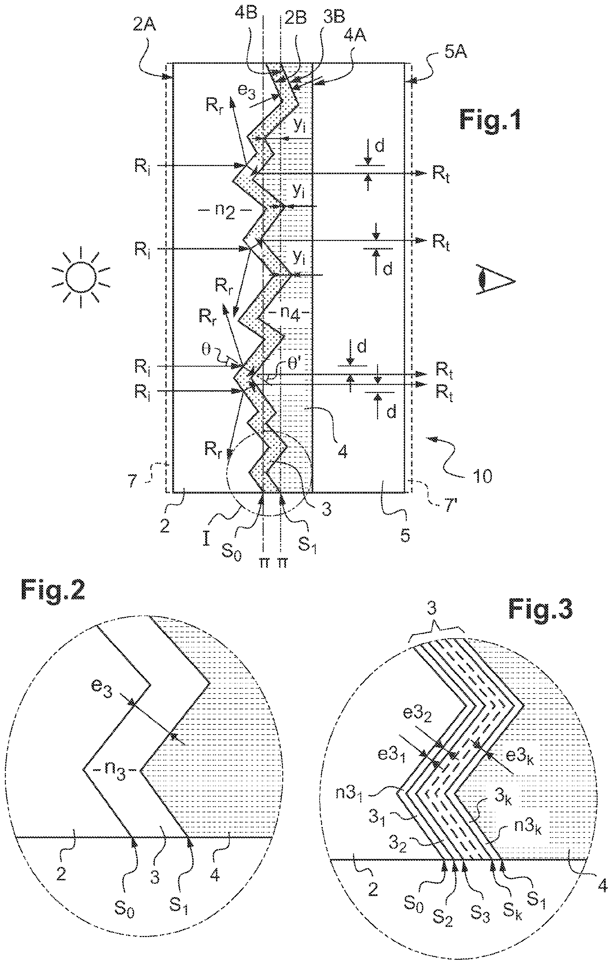

Pour la clarté du dessin, les épaisseurs relatives des différentes couches sur les figures 1 à 9 n'ont pas été rigoureusement respectées. De plus, la possible variation d'épaisseur de la ou chaque couche constitutive de la couche centrale en fonction de la pente de la texture n'a pas été représentée sur les figures, étant entendu que cette possible variation d'épaisseur n'impacte pas le parallélisme des surfaces de contact texturées. En effet, pour chaque pente donnée de la texture, les surfaces de contact texturées sont parallèles entre elles.

Dans le premier mode de réalisation représenté sur la figure 1, l'élément en couches 10 comprend deux couches externes 2 et 4, qui sont constituées en des matériaux diélectriques transparents ayant sensiblement le même indice de réfraction $n_2$, $n_4$. Chaque couche externe 2 ou 4 présente une surface principale lisse, respectivement 2A ou 4A, dirigée vers l'extérieur de l'élément en couches, et une surface principale texturée, respectivement 2B ou 4B, dirigée vers l'intérieur de l'élément en couches.

Les textures des surfaces internes 2B et 4B sont complémentaires l'une de l'autre. Comme bien visible sur la figure 1, les surfaces texturées 2B et 4B sont positionnées en regard l'une de l'autre, dans une configuration où leurs textures sont strictement parallèles entre elles. L'élément en couches 10 comprend également une couche centrale 3, intercalée en contact entre les surfaces texturées 2B et 4B.

Dans la variante montrée sur la figure 2, la couche centrale 3 est monocouche et constituée en un matériau transparent qui est soit métallique, soit diélectrique d'indice de réfraction n3 différent de celui des couches externes 2 et 4.

Dans la variante montrée sur la figure 3, la couche centrale 3 est formée par un empilement transparent de plusieurs couches $3_1, 3_2, ..., 3_k$, où au moins l'une des couches $3_1$ à $3_k$ est soit une couche en matériau métallique, soit une couche en matériau diélectrique d'indice de réfraction différent de celui des couches externes 2 et 4.

Sur les figures 1 à 3, on note $S_0$ la surface de contact entre la couche externe 2 et la couche centrale 3, et $S_1$ la surface de contact entre la couche centrale 3 et la couche externe 4. De plus, sur la figure 3, on note successivement $S_2$ à $S_k$ les surfaces de contact internes de la couche centrale 3, en partant de la surface de contact la plus proche de la surface $S_0$.

Dans la variante de la figure 2, du fait de l'agencement de la couche centrale 3 en contact entre les surfaces texturées 2B et 4B qui sont parallèles entre elles, la surface de contact $S_0$ entre la couche externe 2 et la couche centrale 3 est texturée et parallèle à la surface de contact $S_1$ entre la couche centrale 3 et la couche externe 4. En d'autres termes, la couche centrale 3 est une couche texturée présentant une épaisseur e3 uniforme, prise perpendiculairement aux surfaces de contact $S_0$ et $S_1$.

Dans la variante de la figure 3, chaque surface de contact $S_2, ..., S_k$ entre deux couches adjacentes de l'empilement constitutif de la couche centrale 3 est texturée et strictement parallèle aux surfaces de contact $S_0$ et $S_1$ entre les couches externes 2, 4 et la couche centrale 3. Ainsi, toutes les surfaces de contact $S_0, S_1, ..., S_k$ entre des couches adjacentes de l'élément 10 qui sont soit de natures différentes, diélectrique ou métallique, soit en matériaux diélectriques d'indices de réfraction différents, sont texturées et parallèles entre elles. En particulier, chaque couche $3_1, 3_2, ..., 3_k$ de l'empilement constitutif de la couche centrale 3 présente une épaisseur $e3_1, e3_2, ..., e3_k$ uniforme, prise perpendiculairement aux surfaces de contact $S_0, S_1, ..., S_k$.

Comme montré sur la figure 1, la texture de chaque surface de contact $S_0, S_1$ ou $S_0, S_1, ..., S_k$ de l'élément en couches 10 est formée par une pluralité de motifs en creux ou en saillie par rapport à un plan général $\pi$ de la surface de contact. La hauteur moyenne des motifs de chaque surface de contact texturée $S_0, S_1$ ou $S_0, S_1, ..., S_k$ est comprise entre 1 µm et 2 mm, de préférence entre 2 µm et 200 µm. La hauteur moyenne des motifs de chaque surface de contact texturée est définie comme la moyenne arithmétique $\frac{1}{n}\sum_{i=1}^{n}|y_i|,$ avec $y_i$ la distance prise entre le sommet et le plan $\pi$ pour chaque motif de la surface, comme montré schématiquement sur la figure 1.

Selon un aspect de l'invention, l'épaisseur e3 ou $e3_1, e3_2, ..., e3_k$ de la ou chaque couche constitutive de la couche centrale 3 est inférieure à la hauteur moyenne des motifs de chaque surface de contact texturée $S_0, S_1$ ou $S_0, S_1, ..., S_k$ de l'élément en couches 10. Cette condition est importante pour augmenter la probabilité que l'interface d'entrée d'un rayonnement dans une couche de la couche centrale 3 et l'interface de sortie du rayonnement hors de cette couche soient parallèles, et ainsi augmenter le pourcentage de transmission spéculaire du rayonnement à travers l'élément en couches 10. Dans un souci de visibilité des différentes couches, cette condition n'a pas été strictement respectée sur les figures 1 à 9. En pratique, lorsque la couche centrale 3 est une couche mince ou un empilement de couches minces, l'épaisseur e3 ou $e3_1, e3_2, ..., e3_k$ de chaque couche de la couche centrale 3 est de l'ordre de, ou inférieure à, 1/10 de la hauteur moyenne des motifs de chaque surface de contact texturée de l'élément en couches.

La figure 1 illustre le parcours d'un rayonnement, qui est incident sur l'élément en couches 10 du côté d'une première couche externe 2. Les rayons incidents $R_i$ arrivent sur la première couche externe 2 avec un angle d'incidence θ donné. Une partie du rayonnement incident est réfléchi de manière spéculaire sur la surface externe 2A de la première couche externe 2, du fait de la différence d'indice de réfraction entre l'air et le matériau constitutif de la couche externe 2. Afin de réduire cette réflexion, un revêtement antireflet 7 est avantageusement prévu sur la surface 2A de la première couche externe 2. Comme évoqué précédemment, le revêtement antireflet 7 peut être de tout type permettant de réduire la réflexion de rayonnement à l'interface entre l'air et la première couche externe 2. Il peut s'agir notamment d'une couche d'indice de réfraction compris entre l'indice de réfraction de l'air et l'indice de réfraction de la première couche externe 2, d'un empilement de couches minces jouant le rôle d'un filtre interférentiel, ou encore d'un empilement de couches minces présentant un gradient d'indices de réfraction.

Comme montré sur la figure 1, les rayons incidents $R_i$, lorsqu'ils atteignent une surface de contact $S_i$ entre deux couches adjacentes de natures différentes, diélectrique ou métallique, ou d'indices de réfraction différents, sont réfléchis soit par la surface métallique, soit du fait de la différence d'indice de réfraction à cette surface de contact. Comme la surface de contact $S_i$ est texturée, la réflexion s'opère dans une pluralité de directions $R_r$. La réflexion du

rayonnement par l'élément en couches 10 est alors diffuse.

Une partie du rayonnement incident est également réfractée dans la couche centrale 3. Dans la variante de la figure 2, les surfaces de contact $S_0$ et $S_1$ sont parallèles entre elles, ce qui implique d'après la loi de Snell-Descartes que n2.sin($\theta$) = n4.sin($\theta'$), où $\theta$ est l'angle d'incidence du rayonnement sur la couche centrale 3 à partir de la première couche externe 2 et $\theta'$ est l'angle de réfraction du rayonnement dans la deuxième couche externe 4 à partir de la couche centrale 3. Dans la variante de la figure 3, comme les surfaces de contact $S_0,S_1,...,S_k$ sont toutes parallèles entre elles, la relation n2.sin($\theta$) = n4.sin($\theta'$) issue de la loi de Snell-Descartes reste vérifiée. Dès lors, dans les deux variantes, comme les indices de réfraction n2 et n4 des deux couches externes sont sensiblement égaux l'un à l'autre, les rayons $R_t$ transmis par l'élément en couches sont transmis avec un angle de transmission $\theta'$ égal à leur angle d'incidence $\theta$ sur l'élément en couches. La transmission du rayonnement par l'élément en couches 10 est donc spéculaire.

Du fait de la réfraction dans la couche centrale 3, les rayons transmis $R_t$ sont parallèles aux rayons incidents $R_i$ en étant légèrement déviés par rapport à ceux-ci, comme montré par le décalage d sur la figure 1. En pratique, étant donnée la faible épaisseur de la couche centrale 3, le décalage d est suffisamment faible, notamment de l'ordre de quelques nanomètres, pour ne pas impacter la netteté de la vision à travers l'élément en couches 10.

Il est à noter que, pour les mêmes raisons que précédemment, un rayonnement incident sur l'élément couches 10 du côté de la deuxième couche externe 4 tend également à être réfléchi de manière diffuse et transmis de manière spéculaire par l'élément en couches. L'idée de l'invention est alors de conférer à l'élément en couches 10 une asymétrie, de façon à réduire l'impression de flou ou de "vitrage sale" pour un observateur situé du côté de la deuxième couche externe 4, et ainsi à garantir une vision nette à travers l'élément 10, même lorsque le contraste lumineux entre les deux côtés de l'élément 10 est faible ou nul, voire même lorsque la luminosité du côté de la deuxième couche externe 4 est plus forte que celle du côté de la première couche externe 2.

A cet effet, selon une première approche, on fait en sorte que l'élément en couches 10 comporte des matériaux clairs du côté de la première couche externe 2 par rapport à la couche centrale 3, ayant notamment une transmission lumineuse $T_L$ supérieure ou égale à 80%, et au moins un élément absorbant du côté de la deuxième couche externe 4 par rapport à la couche centrale 3, ayant une transmission lumineuse $T_L$ comprise entre 10% et 60%.

A titre d'exemple, dans le mode de réalisation de la figure 1, la première couche externe 2 est un substrat texturé en verre clair ou extra-clair, par exemple un verre texturé de type SGG SATINOVO® ou SGG ALBARINO® commercialisé par Saint-Gobain Glass, et la deuxième couche externe 4 est formée par un feuillet intercalaire, par exemple en PVB, qui a sensiblement le même indice de réfraction que le substrat 2 et qui se conforme à la texture de la surface texturée 3B de la couche centrale 3. Le feuillet intercalaire 4 est calandré par sa surface externe 4A à un substrat plan 5 en verre teinté, par exemple un verre teinté dans la masse de type SGS THERMOCONTROL® Venus Grey 10 commercialisé par Saint-Gobain Sekurit. Ainsi, dans cet exemple, l'élément absorbant intégré dans l'élément en couches 10 du côté de la deuxième couche externe 4 est le substrat 5. Selon une variante, le feuillet intercalaire 4 peut également jouer le rôle d'élément absorbant, par exemple en sélectionnant un feuillet en PVB teinté dans la masse, qui peut alors être calandré soit à un substrat plan 5 en verre clair ou extra-clair, par exemple un verre de type SGG PLANILUX® commercialisé par Saint-Gobain Glass, soit à un substrat plan 5 en verre teinté comme précédemment.

Selon une deuxième approche, on confère une asymétrie à l'élément en couches 10 en sélectionnant en tant que couche centrale 3 un empilement asymétrique de couches minces $3_1,3_2,...,3_k$ tel que le rapport de la réflexion totale $R_e$ de la couche centrale 3 du côté tourné vers la première couche externe 2 dans un domaine de longueurs d'onde donné, par exemple le domaine de longueurs d'onde du visible, sur la réflexion totale $R_i$ de la couche centrale 3 du côté tourné vers la deuxième couche externe 4 dans ledit domaine de longueurs d'onde donné est supérieur ou égal à 1,5, de préférence supérieur ou égal à 2. De manière avantageuse, cet empilement de couches peut être adapté en outre pour conférer des propriétés de contrôle solaire et/ou de basse émissivité à l'élément en couches 10.

Les première et deuxième approches visant à rendre l'élément en couches 10 asymétrique peuvent bien entendu être combinées, c'est-à-dire que l'élément en couches peut comprendre à la fois une couche centrale 3 formée par un empilement asymétrique de couches minces et au moins un élément absorbant disposé du côté de la deuxième couche externe 4 par rapport à la couche centrale 3.

Quelle que soit l'approche choisie pour rendre l'élément en couches 10 asymétrique, un revêtement antireflet 7' est de préférence prévu sur la surface principale externe de l'élément en couches 10 située du côté de la deuxième couche externe 4, à savoir la surface 5A sur la figure 1, de manière à réduire la réflexion due à la différence d'indice de réfraction entre l'air et le matériau constitutif du substrat 5. La présence du revêtement antireflet 7' est particulièrement importante pour limiter la réflexion spéculaire de rayonnement sur la surface 5A et éviter toute dégradation de la netteté de la vision à travers l'élément 10 pour un observateur placé du côté de la deuxième couche externe 4. De même que le revêtement antireflet 7, le revêtement antireflet 7' peut être de tout type permettant de réduire la réflexion de rayonnement à l'interface entre l'air et le substrat 5. Il peut s'agir notamment d'une couche d'indice de réfraction compris entre l'indice de réfraction de l'air et l'indice de réfraction du substrat 5, d'un empilement de couches minces jouant le rôle d'un filtre interférentiel, ou encore d'un empilement de couches minces présentant un gradient d'indices de réfraction.

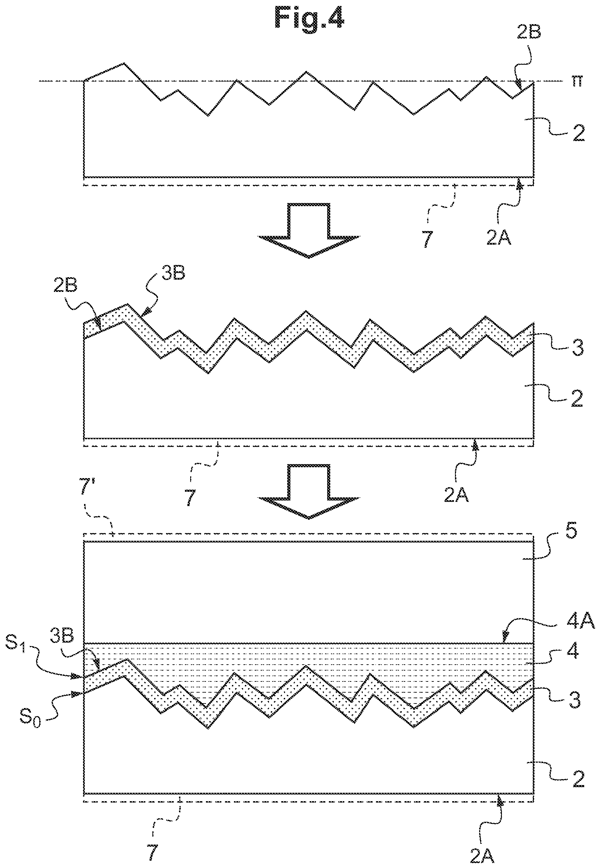

Un exemple de procédé de fabrication de l'élément en couches 10 est décrit ci-après, en référence à la figure 4.

Selon ce procédé, la couche centrale 3 est déposée de manière conforme sur la surface texturée 2B du substrat 2 formant la première couche externe. La surface principale 2A de ce substrat opposée à la surface texturée 2B est lisse et munie du revêtement antireflet 7. Le dépôt conforme de la couche centrale 3, qu'elle soit monocouche ou formée par un empilement de plusieurs couches, est de préférence réalisé, sous vide, par pulvérisation cathodique assistée par champ magnétique (pulvérisation dite "cathodique magnétron"). Cette technique permet de déposer, sur la surface texturée 2B du substrat 2, soit la couche unique de manière conforme, soit les différentes couches de l'empilement successivement de manière conforme. Il peut s'agir en particulier de couches minces diélectriques, notamment des couches de $Si_3N_4$, $SnO_2$, $ZnO$, $SnZnO_x$, $AlN$, $NbO$, $NbN$, $TiO_2$, $SiO_2$, $Al_2O_3$, $MgF_2$, $AlF_3$, ou de couches minces métalliques, notamment des couches d'argent, d'or, de titane, de niobium, de silicium, d'aluminium, d'alliage nickel-chrome (NiCr), ou d'alliages de ces métaux.

La couche centrale 3 peut être, à titre d'exemple :

- une couche de $TiO_2$ ayant une épaisseur comprise entre 55 et 65 nm, et un indice de réfraction de 2,45 à 550 nm, ou
- un empilement de couches comprenant au moins une couche à base d'argent tel que décrit dans les demandes de brevet WO 02/48065 A1 ou EP 0 847 965 A1.

Suite au dépôt de la couche centrale 3, on positionne successivement, en regard du substrat 2 et à partir de la surface principale texturée 3B de la couche centrale 3, le feuillet intercalaire 4 et le substrat 5, et on applique à la structure feuilletée ainsi formée une compression et/ou un chauffage, au moins à la température de transition vitreuse du feuillet intercalaire 4, par exemple dans une presse ou une étuve. Au cours de ce procédé de feuilletage, le feuillet intercalaire 4 se conforme à la texture de la surface texturée 3B de la couche centrale 3, ce qui garantit que la surface de contact $S_1$ entre la couche centrale 3 et la couche externe 4 est bien texturée et parallèle à la surface de contact $S_0$ entre la couche centrale 3 et la couche externe 2.

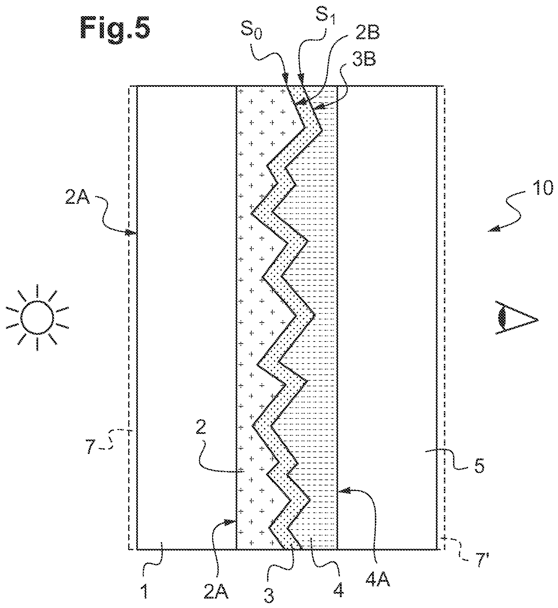

Dans le deuxième mode de réalisation représenté sur la figure 5, les éléments analogues à ceux du premier mode de réalisation portent des références identiques. Ce deuxième mode de réalisation diffère du premier mode de réalisation uniquement en ce que la première couche externe 2 n'est pas un verre texturé, mais un film de polyéthylène téréphtalate (PET) dont une surface principale 2B est texturée, cette texturation pouvant notamment être obtenue par embossage. Ainsi, dans l'élément en couches 10 du deuxième mode de réalisation, la première couche externe 2 est un substrat flexible texturé, qui est solidarisé par sa surface externe lisse 2A à un substrat plan 1 en verre clair ou extra-clair, par exemple un verre de type SGG PLANILUX® commercialisé par Saint-Gobain Glass. Dans ce mode de réalisation, la couche centrale 3 est déposée de manière conforme sur la surface texturée 2B du film 2.

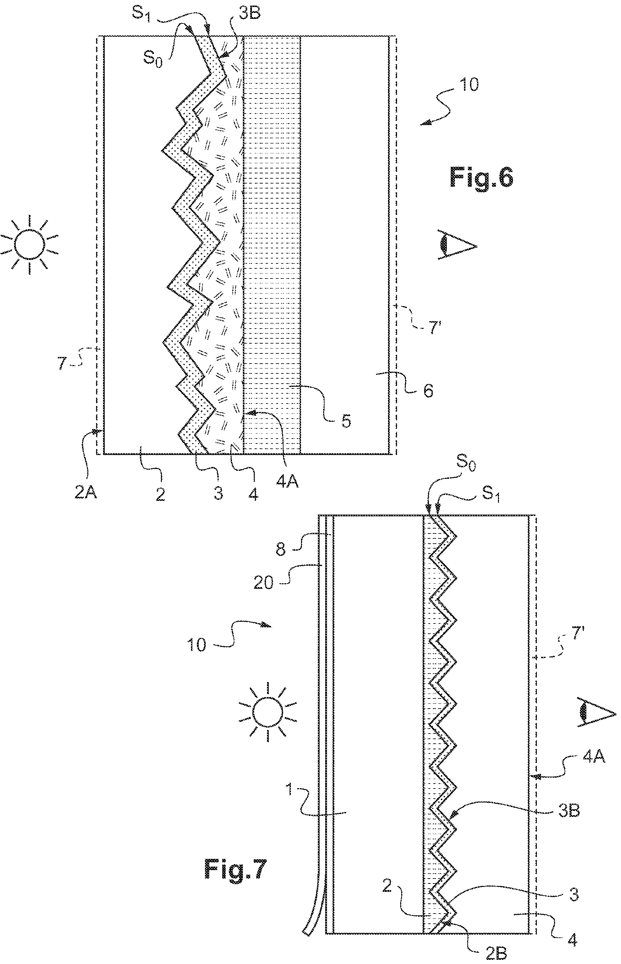

Dans le troisième mode de réalisation représenté sur la figure 6, les éléments analogues à ceux du premier mode de réalisation portent des références identiques. Ce troisième mode de réalisation diffère du premier mode de réalisation uniquement en ce que la deuxième couche externe 4 n'est pas un feuillet intercalaire, mais une couche sol-gel transparente comprenant une matrice hybride organique/inorganique à base de silice, ayant un indice de réfraction sensiblement égal à celui du substrat 2. Cette couche sol-gel 4 est déposée par un procédé sol-gel sur la surface texturée 3B de la couche centrale 3 et vient, à l'état visqueux, liquide ou pâteux, épouser la texture de la surface 3B. Ainsi, on garantit que, à l'état durci de la couche 4, la surface de contact $S_1$ entre la couche centrale 3 et la couche externe 4 est bien texturée et parallèle à la surface de contact $S_0$ entre la couche centrale 3 et la couche externe 2.

De plus, l'élément en couches 10 du troisième mode de réalisation comprend successivement, en tant que couches additionnelles disposées du côté de la deuxième couche externe 4, un feuillet intercalaire 5, par exemple en PVB, qui est calandré par sa surface externe à un substrat plan 6 en verre teinté, par exemple un verre teinté dans la masse de type SGS THERMOCONTROL® Venus Grey 10 commercialisé par Saint-Gobain Sekurit. Ainsi, dans cet exemple, l'élément absorbant intégré dans l'élément en couches 10 du côté de la deuxième couche externe 4 est le substrat 6. Selon une variante, la couche sol-gel 4 et/ou le feuillet intercalaire 5 peuvent également jouer le rôle d'éléments absorbants, par exemple en sélectionnant une couche sol-gel comprenant des colorants en tant qu'additifs ou un feuillet en PVB teinté dans la masse. Dans cette variante, le feuillet intercalaire 5 peut être calandré soit à un substrat plan 6 en verre clair ou extra-clair, par exemple un verre de type SGG PLANILUX® commercialisé par Saint-Gobain Glass, soit à un substrat plan 6 en verre teinté comme précédemment.

Dans le quatrième mode de réalisation représenté sur la figure 7, les éléments analogues à ceux du premier mode de réalisation portent des références identiques. Dans ce quatrième mode de réalisation, l'élément en couches 10 est un film flexible d'épaisseur totale de l'ordre de 50-300 μm. La première couche externe 2 de cet élément en couches est une couche en matériau photoréticulable et/ou photopolymérisable sous l'action d'un rayonnement UV, qui est texturée sur l'une de ses faces principales 2B. La couche 2 est appliquée par sa surface principale non texturée contre l'une des surfaces principales d'un film flexible 1 en matériau polymère, dont les deux surfaces principales sont lisses. A titre d'exemple, le film 1 est un film de polyéthylène téréphtalate (PET) ayant une épaisseur de 100 μm, qui a de préférence une résistance aux UV renforcée, et la couche 2 est une couche de résine durcissable aux UV de type KZ6661 commercialisée par JSR Corporation ayant une épaisseur d'environ 10 μm. A l'état durci, la couche de résine 2 présente une bonne adhésion avec le PET.

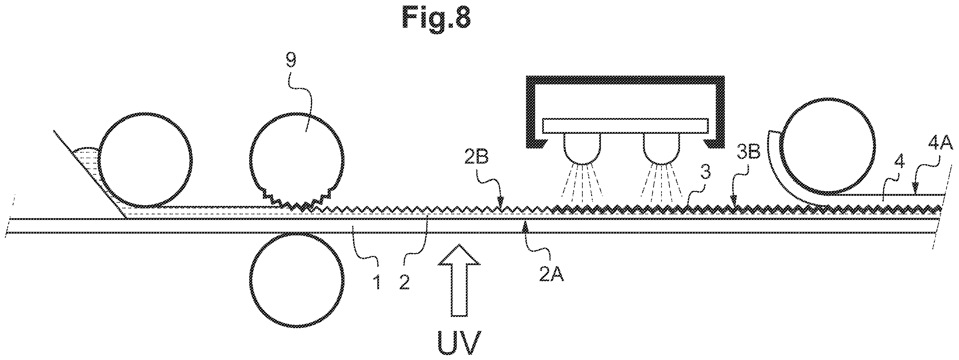

La couche de résine 2 est appliquée sur le film 1 avec une viscosité permettant la mise en place d'une texturation sur sa surface 2B opposée au film 1. La texturation de la surface 2B peut être réalisée par toute technique appropriée, notamment par embossage. Dans l'exemple de la figure 8, la texturation de la surface 2B est réalisée à l'aide d'un rouleau 9 ayant à sa surface une texturation complémentaire de celle à former sur la couche 2. Une fois la texturation formée et/ou au cours de sa formation, le film 1 et la couche de résine 2 superposés sont irradiés avec un rayonnement UV, comme montré par la flèche de la figure 8, ce qui permet la solidification de la couche de résine 2 avec sa texturation et l'assemblage entre le film 1 et la couche de résine 2.

Une couche centrale 3, qui peut être monocouche ou formée par un empilement de couches comme décrit précédemment et qui comprend au moins une couche en matériau métallique ou en matériau diélectrique d'indice de réfraction différent de celui de la première couche externe 2, est ensuite déposée de manière conforme sur la surface texturée 2B, notamment par pulvérisation cathodique magnétron.

Un deuxième film de PET ayant une épaisseur de 100 $\mu$m, cette fois-ci teinté dans la masse de manière à former un élément absorbant, est ensuite déposé sur la couche centrale 3 et forme la deuxième couche externe 4 de l'élément en couches 1. Le film flexible 4 et la couche 2 ont tous les deux sensiblement le même indice de réfraction, de l'ordre de 1,65 à 550 nm. Le film flexible 4 est conformé à la surface texturée 3B de la couche centrale 3 opposée à la première couche externe 2 par compression et/ou chauffage à la température de transition vitreuse du PET.

Une couche d'adhésif 8 de type PSA (pressure sensitive adhesive), recouverte d'une bande de protection (liner) 20 destinée à être retirée pour le collage, peut être rapportée sur l'une ou l'autre des surfaces externes de l'élément en couches 10, de préférence sur la surface externe située du côté de la première couche externe 2, c'est-à-dire la surface externe du film 1 comme montré sur la figure 7. L'élément en couches 10 se présente ainsi sous la forme d'un film flexible prêt à être rapporté par collage sur une surface, telle qu'une surface d'un vitrage, afin de conférer à cette surface des propriétés de réflexion diffuse. Dans l'exemple de la figure 7, la surface externe du film 4 est munie d'un revêtement antireflet 7'.

De manière particulièrement avantageuse, comme suggéré sur la figure 8, les différentes étapes du procédé peuvent être effectuées en continu sur une même ligne de fabrication.

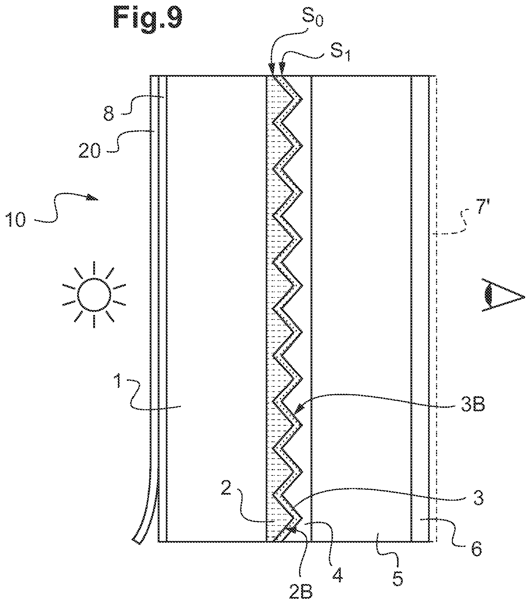

Dans le cinquième mode de réalisation représenté sur la figure 9, les éléments analogues à ceux du premier mode de réalisation portent des références identiques. Comme dans le quatrième mode de réalisation, l'élément en couches 10 de ce cinquième mode de réalisation est un film flexible d'épaisseur totale de l'ordre de 50-300 $\mu$m dont la première couche externe 2 est une couche en matériau photoréticulable et/ou photopolymérisable sous l'action d'un rayonnement UV, qui est texturée sur l'une de ses faces principales 2B et appliquée par sa surface principale non texturée contre une surface principale d'un film flexible 1 en matériau polymère ayant ses deux surfaces principales lisses. La texturation de la surface 2B de la couche 2 peut être réalisé par toute technique appropriée, notamment par embossage.

Ce cinquième mode de réalisation diffère du quatrième mode de réalisation en ce que la deuxième couche externe 4 n'est pas un film en matériau polymère, mais une couche d'adhésif choisi pour avoir un accord d'indice de réfraction avec la couche 2 en matériau photoréticulable et/ou photopolymérisable. La couche d'adhésif 4 assure la jonction entre la couche centrale 3 et un deuxième film 5 en matériau polymère, qui est teinté dans la masse de manière à former un élément absorbant. Une couche protectrice 6, de type couche anti-rayure ou "hardcoat layer", est avantageusement appliquée sur la surface principale extérieure du film 5, opposée à la couche d'adhésif 4. On note que l'accord d'indice de réfraction qui importe dans ce mode de réalisation est celui entre la couche 2 en matériau photoréticulable et/ou photopolymérisable et la couche d'adhésif 4. Ce cinquième mode de réalisation permet ainsi d'avoir un choix plus vaste de matériaux pour la couche 2, puisqu'il n'est plus nécessaire que la couche 2 ait sensiblement le même indice de réfraction que le film 5.

A titre d'exemple, dans l'élément en couches 10 de ce cinquième mode de réalisation : le film 1 est un film de PET ayant une épaisseur de 25 $\mu$m, qui a de préférence une résistance aux UV renforcée ; la couche 2 est une couche de résine à base d'acrylates photoréticulable sous l'action d'un rayonnement UV ayant une épaisseur comprise entre 1 $\mu$m et 10 $\mu$m et un indice de réfraction de l'ordre de 1,52 à 550 nm ; la couche centrale 3 est une couche unique ou un empilement de couches comprenant au moins une couche en matériau métallique ou en matériau diélectrique d'indice de réfraction différent de celui de la couche 2, déposée de manière conforme sur la surface texturée 2B, notamment par pulvérisation cathodique magnétron ; la couche 4 est une couche d'adhésif de type PSA (pressure sensitive adhesive) ayant une épaisseur comprise entre 1 $\mu$m et 10 $\mu$m et un indice de réfraction de l'ordre de 1,52 à 550 nm ; le film 5 est un film de PET teinté dans la masse ayant une épaisseur comprise entre 25 $\mu$m et 50 $\mu$m.

Comme dans le quatrième mode de réalisation, une couche d'adhésif 8 de type PSA (pressure sensitive adhesive), recouverte d'une bande de protection (liner) 20 destinée à être retirée pour le collage, est rapportée sur la surface externe du film 1. L'élément en couches 10 se présente ainsi sous la forme d'un film flexible prêt à être rapporté par collage sur une surface, telle qu'une surface d'un vitrage, afin de conférer à cette surface des propriétés de réflexion diffuse. Un revêtement antireflet 7' peut également être prévu sur la surface externe de l'élément en couches 10 du côté opposé à la couche d'adhésif 8.

Il est à noter que, dans chacun des modes de réalisation décrits précédemment, le revêtement antireflet 7 ou 7' peut être mis en place, sur la surface externe correspondante de l'élément en couches, avant ou après l'assemblage de l'élément en couches, de manière indifférente.

L'invention n'est pas limitée aux exemples décrits et représentés. En particulier, lorsque l'élément en couches est un film flexible comme dans les exemples des figures 7 à 9, l'épaisseur de chaque couche formée à base d'un film polymère, par exemple à base d'un film de PET, peut être différente de celles décrites précédemment, notamment de l'ordre de 10 $\mu$m à 1 mm.

De plus, la texturation de la première couche externe 2 dans les exemples des figures 7 à 9 peut être obtenue sans recourir à une couche de résine durcissable déposée sur un film polymère, mais directement par embossage à chaud d'un film polymère, notamment par laminage à l'aide d'un rouleau texturé ou par pressage à l'aide d'un poinçon.

Des architectures analogues aux modes de réalisation des figures 1 à 6 peuvent également être envisagées avec des substrats plastiques à la place des substrats en verre.

L'élément en couches selon l'invention est susceptible d'être utilisé pour toutes applications connues de vitrages, telles que pour véhicules, bâtiments, mobilier urbain, ameublement intérieur, dispositifs d'éclairage, supports d'affichage, écrans de projection, etc., où l'on souhaite obtenir des propriétés de transmission spéculaire et de réflexion diffuse d'un rayonnement incident sur le vitrage du côté d'une première couche externe de l'élément en couches, tout en ayant un haut niveau de netteté de vision à travers le vitrage pour un observateur placé du côté de la deuxième couche externe de l'élément en couches, même lorsque le contraste lumineux entre les deux côtés du vitrage est relativement faible ou nul, voire même lorsque la luminosité du côté de la deuxième couche externe est plus forte que celle du côté de la première couche externe.

**Exemples**

Les propriétés optiques de quatre exemples d'éléments en couches sont données dans le Tableau 1 ci-après.

Dans l'exemple n°1, la première couche externe 2 est formée par un verre teinté SGS THERMOCONTROL® Venus Green 35 d'épaisseur 2 mm, sur une surface principale duquel une texture a été formée par sablage.

Dans chaque exemple, la couche centrale 3 est un empilement de couches déposée par dépôt magnétron de manière conforme sur la surface texturée du substrat texturé formant la première couche externe 2.

Dans les exemples n°1 et n°2, la couche centrale 3 est un empilement de contrôle solaire comprenant deux couches minces à base d'argent, dit « SKN 144 », correspondant au produit référencé SGG COOL-LITE® SKN 144 II chez Saint-Gobain Glass.

Les propriétés optiques des éléments en couches données dans le Tableau 1 sont les suivantes :

- $R_{utile}$ : la réflexion lumineuse totale dans le visible en % de l'élément en couches pour un rayonnement en incidence normale sur l'élément en couches du côté de la première couche externe 2, mesurée selon la norme ISO 9050:2003 (illuminant D65 ; 2° Observateur) ;

- $R_{parasite}$ : la réflexion lumineuse totale dans le visible en % de l'élément en couches pour un rayonnement en incidence normale sur l'élément en couches du côté de la deuxième couche externe 4, mesurée selon la norme ISO 9050:2003 (illuminant D65 ; 2° Observateur) ;

- $T_{utile}$ : la transmission lumineuse dans le visible en % de l'élément en couches, mesurée selon la norme ISO 9050:2003 (illuminant D65 ; 2° Observateur), où la mesure est faite avec le rayonnement en incidence normale qui traverse l'élément en couches en allant de la première couche externe 2 vers la deuxième couche externe 4 ;

- $R_e$ : la réflexion lumineuse totale dans le visible en % de la couche centrale 3 du côté de la première couche externe 2, mesurée selon la norme ISO 9050:2003 (illuminant D65 ; 2° Observateur), où la mesure est faite avec la couche centrale 3 déposée sur un verre plan de type SGG PLANILUX® d'épaisseur 4 mm et avec le rayonnement en incidence normale sur la couche centrale 3 du côté qui est adjacent à la première couche externe 2 dans l'élément en couches ;

- $R_i$ : la réflexion lumineuse totale dans le visible en % de la couche centrale 3 du côté de la deuxième couche externe 4, mesurée selon la norme ISO 9050:2003 (illuminant D65 ; 2° Observateur), où la mesure est faite avec la couche centrale 3 déposée sur un verre plan de type SGG PLANILUX® d'épaisseur 4 mm et avec le rayonnement en incidence normale sur la couche centrale 3 du côté qui est adjacent à la deuxième couche externe 4 dans l'élément en couches ;

- T : la transmission lumineuse dans le visible en % de la couche centrale 3, mesurée selon la norme ISO 9050:2003 (illuminant D65 ; 2° Observateur), où la mesure est faite avec la couche centrale 3 déposée sur un verre plan de type SGG PLANILUX® d'épaisseur 4 mm et avec le rayonnement en incidence normale qui traverse la couche centrale 3 en allant du côté qui est adjacent à la première couche externe 2 dans l'élément en couches vers le côté qui est adjacent à la deuxième couche externe 4 dans l'élément en couches.

**Tableau 1**

| Exemple | n°1 (comparatif) | n°2 | n°3 (comparatif) | n°4 |
|---|---|---|---|---|
| Première couche externe 2 | SGS THERMOCONTROL® Venus Green 35 2 mm texturé | SGG SATINOVO® 4 mm | SGG SATINOVO® 4 mm | SGG SATINOVO® 4 mm |
| Couche centrale 3 (en partant de la première couche externe 2) | SKN 144 | SKN 144 | SiN          20 nm<br>NiCr         1,5 nm<br>Ag           18 nm<br>NiCr         1,5 nm<br>SiN          20 nm<br><br>$R_e = R_i = 32\ \%$<br>$T = 30\ \%$ | $Si_3N_4$       50 nm<br>NiCr          1,5 nm<br>Ag            10 nm<br>NiCr          1,5 nm<br>NbN           15 nm<br>$Si_3N_4$       50 nm<br><br>$R_e = 27\ \%$<br>$R_i = 11\ \%$<br>$T = 30\ \%$ |
| Deuxième couche externe 4 | PVB 0,38 mm | PVB 0,38 mm | PVB 0,38 mm | PVB 0,38 mm |
| Couche additionnelle 5 du côté de la deuxième couche externe 4 | SGS THERMOCONTROL® Venus Green 35 2 mm | SGS THERMOCONTROL® Venus Grey 10 2 mm | SGG PLANILUX® 4 mm | SGG PLANILUX® 4 mm |
| Propriétés de l'élément en couches | | | | |
| $R_{utile}$ (%) | 6 % | 18,5 % | 33 % | 28,5 % |
| $R_{parasite}$ (%) | 6 % | 4,5 % | 33 % | 14 % |
| $T_{utile}$ (%) | 13 % | 13 % | 25,5 % | 25,5 % |

Une comparaison des propriétés des exemples n°1 et n°2 montre qu'en intégrant dans l'exemple n°2 un élément clair du côté de la première couche externe 2, à savoir un verre clair SGG SATINOVO® d'épaisseur 4 mm, et un élément absorbant du côté de la deuxième couche externe 4, à savoir un verre teinté SGS THERMOCONTROL® Venus Grey 10 d'épaisseur 2 mm, on augmente les rapports $R_{utile}/R_{parasite}$ et $T_{utile}/R_{parasite}$, tout en gardant la même valeur de $T_{utile}$, par rapport à l'exemple n°1 où l'élément en couches comprend des substrats identiques de part et d'autre de la couche centrale 3. Il en résulte, pour un observateur placé du côté de la deuxième couche externe 4, une réduction de l'impression de flou ou de "vitrage sale", et donc une vision plus nette, à travers l'élément en couches de l'exemple n°2 conforme à l'invention, par rapport à l'élément en couches de l'exemple n°1 comparatif.

De même, une comparaison des propriétés des exemples n°3 et n°4 montre qu'en rendant la couche centrale 3 asymétrique dans l'exemple n°4 de sorte que $R_e/R_i$ est supérieur ou égal à 1,5, on augmente les rapports $R_{utile}/R_{parasite}$ et $T_{utile}/R_{parasite}$, tout en gardant la même valeur de $T_{utile}$ et une valeur élevée de $R_{utile}$, par rapport à l'exemple n°3 où l'élément en couches comprend une couche centrale 3 symétrique. Ici encore, il en résulte, pour un observateur placé du côté de la deuxième couche externe 4, une réduction de l'impression de flou ou de "vitrage sale", et donc une vision plus nette, à travers l'élément en couches de l'exemple n°4 conforme à l'invention, par rapport à l'élément en couches de l'exemple n°3 comparatif.

**Revendications**

1.  Elément en couches (10) transparent ayant deux surfaces principales externes lisses et comprenant :

   - deux couches externes (2, 4), qui ont chacune une surface principale externe (2A, 4A) lisse et qui sont constituées en des matériaux diélectriques ayant sensiblement le même indice de réfraction (n2, n4), et
- une couche centrale (3) intercalée entre les couches externes, cette couche centrale (3) étant formée soit par une couche unique en matériau métallique ou en matériau diélectrique d'indice de réfraction (n3) différent de celui des couches externes, soit par un empilement de couches ($3_1$, $3_2$, ..., $3_k$) qui comprend au moins une couche en matériau métallique ou en matériau diélectrique d'indice de réfraction (n3) différent de celui des couches externes,

où toutes les surfaces de contact ($S_0$, $S_1$, ..., $S_k$) entre deux couches adjacentes de l'élément en couches qui sont l'une en matériau métallique et l'autre en matériau diélectrique, ou qui sont deux couches en matériaux diélectriques d'indices de réfraction différents, sont texturées et parallèles entre elles, **caractérisé en ce que** le rapport de la réflexion totale ($R_{utile}$) de l'élément en couches (10) du côté d'une première couche externe (2) dans un domaine de longueurs d'onde donné sur la réflexion totale ($R_{parasite}$) de l'élément en couches (10) du côté de la deuxième couche externe (4) dans ledit domaine de longueurs d'onde donné est supérieur ou égal à 1,5, de préférence supérieur ou égal à 2, encore de préférence supérieur ou égal à 3.

2.   Elément en couches selon la revendication 1, **caractérisé en ce que** l'absorption de l'élément en couches (10) dans ledit domaine de longueurs d'onde donné pour un rayonnement incident du côté de la deuxième couche externe (4) est strictement supérieure à l'absorption de l'élément en couches (10) dans ledit domaine de longueurs d'onde donné pour un rayonnement incident du côté de la première couche externe (2).

3.   Elément en couches selon l'une quelconque des revendications 1 ou 2, **caractérisé en ce que** le rapport de la transmission ($T_{utile}$) de l'élément en couches (10) dans ledit domaine de longueurs d'onde donné sur la réflexion totale ($R_{parasite}$) de l'élément en couches (10) du côté de la deuxième couche externe (4) dans ledit domaine de longueurs d'onde donné est supérieur ou égal à 1,5, de préférence supérieur ou égal à 2.

4.   Elément en couches selon l'une quelconque des revendications précédentes, **caractérisé en ce qu'**il comprend, soit en tant que deuxième couche externe (4), soit en tant que couche additionnelle (5, 6) disposée du côté de la deuxième couche externe (4), au moins un élément absorbant dans le domaine de longueurs d'onde du visible.

5.   Elément en couches selon la revendication 4, **caractérisé en ce que** l'élément absorbant a une transmission lumineuse ($T_L$) comprise entre 10% et 60%.

6.   Elément en couches selon l'une quelconque des revendications 4 ou 5, **caractérisé en ce que** l'élément absorbant est un substrat rigide ou flexible, notamment en verre ou en matériau organique polymérique, qui est teinté dans la masse.

7.   Elément en couches selon l'une quelconque des revendications 4 à 6, **caractérisé en ce que** l'élément absorbant est un feuillet intercalaire polymérique qui est teinté dans la masse.

8.   Elément en couches selon l'une quelconque des revendications 4 à 7, **caractérisé en ce que** l'élément absorbant est une couche mince absorbante disposée sur une face d'un substrat rigide ou flexible, notamment en verre ou en matériau organique polymérique, ou sur une face d'un feuillet intercalaire polymérique.

9.   Elément en couches selon l'une quelconque des revendications précédentes, **caractérisé en ce que** la couche centrale (3) est un empilement de couches minces comprenant une alternance de « n » couches fonctionnelles métalliques, notamment de couches fonctionnelles à base d'argent ou d'alliage métallique contenant de l'argent, et de « (n + 1) » revêtements antireflet, avec n ≥ 1, où chaque couche fonctionnelle métallique est disposée entre deux revêtements antireflet.

10.  Elément en couches selon l'une quelconque des revendications précédentes, **caractérisé en ce que** la couche centrale (3) est un empilement asymétrique de couches minces, le rapport de la réflexion totale ($R_e$) de la couche centrale (3) du côté tourné vers la première couche externe (2) dans ledit domaine de longueurs d'onde donné sur la réflexion lumineuse totale ($R_i$) de la couche centrale (3) du côté tourné vers la deuxième couche externe (4) dans ledit domaine de longueurs d'onde donné étant supérieur ou égal à 1,5, de préférence supérieur ou égal à 2.

11.  Elément en couches selon l'une quelconque des revendications précédentes, **caractérisé en ce que** la valeur absolue de la différence d'indice de réfraction à 550 nm entre, d'une part, les couches externes (2, 4) et, d'autre part, au moins une couche en matériau diélectrique de la couche centrale (3) est supérieure ou égale à 0,30, de préférence supérieure ou égale à 0,50.

12. Elément en couches selon l'une quelconque des revendications précédentes, **caractérisé en ce que** la valeur absolue de la différence d'indice de réfraction à 550 nm entre les matériaux diélectriques constitutifs des deux couches externes (2, 4) est inférieure ou égale à 0,150, de préférence inférieure ou égale à 0,050.

13. Elément en couches selon l'une quelconque des revendications précédentes, **caractérisé en ce que** l'une des deux couches externes (2, 4) comprend un substrat rigide ou flexible, notamment en verre ou en matériau organique polymérique, dont une surface principale est texturée.

14. Elément en couches selon l'une quelconque des revendications 1 à 12, **caractérisé en ce que** l'une des deux couches externes (2, 4) comprend une couche conformable dont une surface principale est texturée et qui est rapportée par son autre surface principale sur un substrat rigide ou flexible.

15. Elément en couches selon l'une quelconque des revendications 13 ou 14, **caractérisé en ce que** l'autre couche externe (4, 2) comprend une couche sol-gel d'accord d'indice de réfraction comprenant une matrice hybride organique/inorganique à base de silice.

16. Elément en couches selon l'une quelconque des revendications précédentes, **caractérisé en ce que** la ou chaque couche constitutive de la couche centrale (3) est une couche déposée par pulvérisation cathodique sur une surface texturée.

17. Elément en couches selon l'une quelconque des revendications précédentes, **caractérisé en ce qu'**il comprend, sur sa surface principale externe située du côté de la deuxième couche externe (4), un revêtement antireflet (7') à l'interface entre l'air et le matériau constitutif de la couche formant cette surface principale externe.

18. Elément en couches selon l'une quelconque des revendications précédentes, **caractérisé en ce que** les surfaces principales externes de l'élément en couches sont bombées.

19. Vitrage de véhicule, bâtiment, mobilier urbain, ameublement intérieur, dispositif d'éclairage, support d'affichage, écran de projection, comprenant au moins un élément en couches (10) selon l'une quelconque des revendications 1 à 18.

**Patentansprüche**

1. Element aus transparenten Schichten (10) mit zwei glatten äußeren Hauptoberflächen und umfassend:

- zwei äußere Schichten (2, 4), die jeweils eine glatte äußere Hauptoberfläche (2A, 4A) aufweisen und die aus dielektrischen Materialien mit im Wesentlichen demselben Brechungsindex (n2, n4) bestehen, und
- eine zwischen den äußeren Schichten angeordnete mittlere Schicht (3), wobei diese mittlere Schicht (3) entweder aus einer einzelnen Schicht aus metallischem Material oder aus dielektrischem Material mit einem Brechungsindex (n3), der sich von dem der äußeren Schichten unterscheidet, oder aus einem Stapel von Schichten ($3_1$, $3_2$, ..., $3_k$) gebildet ist, der mindestens eine Schicht aus metallischem Material oder aus dielektrischem Material mit einem Brechungsindex (n3) umfasst, der sich von dem der äußeren Schichten unterscheidet,

wobei alle Kontaktoberflächen ($S_0$, $S_1$, ..., $S_k$) zwischen zwei benachbarten Schichten des Elements aus Schichten, von denen die eine aus metallischem Material und die andere aus dielektrischem Material besteht oder die zwei Schichten aus dielektrischem Material mit unterschiedlichen Brechungsindizes sind, strukturiert und parallel zueinander sind, **dadurch gekennzeichnet, dass** das Verhältnis der Totalreflexion ($R_{nützlich}$) des Elements aus Schichten (10) an der Seite einer ersten äußeren Schicht (2) in einem gegebenen Wellenlängenbereich auf der Totalreflexion ($R_{störend}$) des Elements aus Schichten (10) auf der Seite der zweiten äußeren Schicht (4) in dem gegebenen Wellenlängenbereich größer als oder gleich 1,5 ist, vorzugsweise größer als oder gleich 2, noch bevorzugter größer als oder gleich 3.

2. Element aus Schichten nach Anspruch 1, **dadurch gekennzeichnet, dass** die Absorption des Elements aus Schichten (10) in dem gegebenen Wellenlängenbereich für einfallende Strahlung auf der Seite der zweiten äußeren Schicht (4) streng größer als die Absorption des Elements aus Schichten (10) in dem gegebenen Wellenlängenbereich für eine Strahlung ist, die auf der Seite der ersten äußeren Schicht (2) einfällt.

3. Element aus Schichten nach einem der vorstehenden Ansprüche 1 oder 2, **dadurch gekennzeichnet, dass** das Verhältnis der Transmission ($T_{nützlich}$) des Elements aus Schichten (10) in dem gegebenen Wellenlängenbereich zur Totalreflexion ($R_{störend}$) des Elements aus Schichten (10) auf der Seite der zweiten äußeren Schicht (4) in dem gegebenen Wellenlängenbereich größer als oder gleich 1,5 ist, vorzugsweise größer als oder gleich 2.

4. Element aus Schichten nach einem der vorstehenden Ansprüche, **dadurch gekennzeichnet, dass** es entweder als zweite äußere Schicht (4) oder als zusätzliche Schicht (5, 6), die auf der Seite der zweiten äußeren Schicht (4) angeordnet ist, mindestens ein absorbierendes Element im Wellenlängenbereich sichtbar umfasst.

5. Element aus Schichten nach Anspruch 4, **dadurch gekennzeichnet, dass** das absorbierende Element eine Lichtdurchlässigkeit ($T_L$) zwischen 10 % und 60 % aufweist.

6. Element aus Schichten nach einem der Ansprüche 4 oder 5, **dadurch gekennzeichnet, dass** das absorbierende Element ein starres oder flexibles Substrat ist, insbesondere aus Glas oder aus polymerem organischem Material, das in der Masse getönt ist.

7. Element aus Schichten nach einem der Ansprüche 4 bis 6, **dadurch gekennzeichnet, dass** das absorbierende Element eine polymere Zwischenschicht, die in der Masse getönt ist, ist.

8. Element aus Schichten nach einem der Ansprüche 4 bis 7, **dadurch gekennzeichnet, dass** das absorbierende Element eine dünne absorbierende Schicht ist, die auf einer Seite eines starren oder flexiblen Substrats, insbesondere aus Glas oder aus polymerem organischem Material, oder auf einer Seite einer polymeren Zwischenschicht angeordnet ist.

9. Element aus Schichten nach einem der vorstehenden Ansprüche, **dadurch gekennzeichnet, dass** die mittlere Schicht (3) ein Stapel dünner Schichten ist, umfassend einen Wechsel von "n" metallischen Funktionsschichten, insbesondere Funktionsschichten auf der Basis von Silber oder einer silberhaltigen Metalllegierung, und "(n + 1)" Antireflexbeschichtungen mit jeweils n ≥ 1, wobei eine metallische Funktionsschicht zwischen zwei Antireflexbeschichtungen angeordnet ist.

10. Element aus Schichten nach einem der vorstehenden Ansprüche, **dadurch gekennzeichnet, dass** die mittlere Schicht (3) ein unsymmetrischer Stapel dünner Schichten ist, wobei das Verhältnis der Totalreflexion ($R_e$) der mittleren Schicht (3) auf der Seite, die zu der ersten äußeren Schicht (2) in dem gegebenen Wellenlängenbereich gerichtet ist, zur Totalreflexion ($R_i$) der mittleren Schicht (3) auf der Seite, die zu der zweiten äußeren Schicht (4) in dem gegebenen Wellenlängenbereich gerichtet ist, größer oder gleich 1,5 ist, vorzugsweise größer als oder gleich 2.

11. Element aus Schichten nach einem der vorstehenden Ansprüche, **dadurch gekennzeichnet, dass** der Absolutwert der Differenz des Brechungsindex bei 550 nm zwischen einerseits den äußeren Schichten (2, 4) und andererseits mindestens einer Schicht aus dielektrischem Material der mittleren Schicht (3) größer als oder gleich 0,30 ist, vorzugsweise größer als oder gleich 0,50.

12. Element aus Schichten nach einem der vorstehenden Ansprüche, **dadurch gekennzeichnet, dass** der Absolutwert der Differenz des Brechungsindex bei 550 nm zwischen den dielektrischen Trägermaterialien der beiden äußeren Schichten (2, 4) kleiner als oder gleich 0,150 ist, vorzugsweise kleiner als oder gleich 0,050.

13. Element aus Schichten nach einem der vorstehenden Ansprüche, **dadurch gekennzeichnet, dass** die eine der beiden äußeren Schichten (2, 4) ein starres oder flexibles Substrat ist, insbesondere aus Glas oder aus polymerem organischem Material, dessen eine Hauptoberfläche strukturiert ist.

14. Element aus Schichten nach einem der Ansprüche 1 bis 12, **dadurch gekennzeichnet, dass** die eine der beiden äußeren Schichten (2, 4) eine anpassungsfähige Schicht umfasst, deren eine Hauptoberfläche strukturiert ist und die durch ihre andere Hauptoberfläche mit einem starren oder flexiblen Substrat verbunden ist.

15. Element aus Schichten nach einem der Ansprüche 13 oder 14, **dadurch gekennzeichnet, dass** die andere äußere Schicht (4, 2) eine Sol-Gel-Schicht umfasst, die dem Brechungsindex entspricht und eine hybride Matrix auf Basis von organischer/anorganischer Kieselsäure umfasst.

16. Element aus Schichten nach einem der vorstehenden Ansprüche, **dadurch gekennzeichnet, dass** die oder jede Trägerschicht der mittleren Schicht (3) eine Schicht ist, die durch Kathodenzerstäubung auf einer strukturierten Oberfläche abgeschieden wird.

17. Element aus Schichten nach einem der vorstehenden Ansprüche, **dadurch gekennzeichnet, dass** es auf seiner äußeren Hauptoberfläche, die sich auf der Seite der zweiten äußeren Schicht (4) befindet, eine Antireflexbeschichtung (7') an der Schnittstelle zwischen der Luft und dem Trägermaterial der Schicht, die diese äußere Hauptoberfläche bildet, umfasst.

18. Element aus Schichten nach einem der vorstehenden Ansprüche, **dadurch gekennzeichnet, dass** die äußeren Hauptoberflächen des Elements aus Schichten gebogen sind.

19. Fahrzeugverglasung, Gebäude, Stadtmöblierung, Innenausstattung, Beleuchtungsvorrichtung, Anzeigehalterung, Projektionswand, umfassend mindestens ein Element aus Schichten (10) nach einem der Ansprüche 1 bis 18.

**Claims**

1. A transparent layered element (10) having two smooth outer main surfaces and comprising:

   - two outer layers (2, 4), which each have a smooth outer main surface (2A, 4A) and which are constituted of dielectric materials having substantially the same refractive index (n2, n4), and
   - a central layer (3) inserted between the outer layers, this central layer (3) being formed either by a single layer made of metallic material or made of dielectric material having a refractive index (n3) different from that of the outer layers, or by a stack of layers ($3_1$, $3_2$, ..., $3_k$) which comprises at least one layer made of metallic material or made of dielectric material having a refractive index (n3) different from that of the outer layers,

   where all the contact surfaces ($S_0$, $S_1$, ..., $S_k$) between two adjacent layers of the layered element which are one made of metallic material and the other made of dielectric material, or which are two layers made of dielectric materials having different refractive indices, are textured and parallel to one another, **characterized in that** the ratio of the total reflection ($R_{effective}$) of the layered element (10) on the side of a first outer layer (2) in a given wavelength range to the total reflection ($R_{stray}$) of the layered element (10) on the side of the second outer layer (4) in said given wavelength range is greater than or equal to 1.5, preferably greater than or equal to 2, more preferably greater than or equal to 3.

2. The layered element as claimed in claim 1, **characterized in that** the absorption of the layered element (10) in said given wavelength range for a radiation incident on the side of the second outer layer (4) is strictly greater than the absorption of the layered element (10) in said given wavelength range for a radiation incident on the side of the first outer layer (2).

3. The layered element as claimed in either one of claims 1 and 2, **characterized in that** the ratio of the transmission ($T_{effective}$) of the layered element (10) in said given wavelength range to the total reflection ($R_{stray}$) of the layered element (10) on the side of the second outer layer (4) in said given wavelength range is greater than or equal to 1.5, preferably greater than or equal to 2.

4. The layered element as claimed in any one of the preceding claims, **characterized in that** it comprises, either as second outer layer (4), or as additional layer (5, 6) positioned on the side of the second outer layer (4), at least one element that absorbs in the visible wavelength range.

5. The layered element as claimed in claim 4, **characterized in that** the absorbent element has a light transmission ($T_L$) of between 10% and 60%.

6. The layered element as claimed in either one of claims 4 and 5, **characterized in that** the absorbent element is a rigid or flexible substrate, in particular made of glass or made of organic polymer material, which is bulk-tinted.

7. The layered element as claimed in any one of claims 4 to 6, **characterized in that** the absorbent element is a polymer interlayer sheet which is bulk-tinted.

8. The layered element as claimed in any one of claims 4 to 7, **characterized in that** the absorbent element is an absorbent thin layer positioned on one face of a rigid or flexible substrate, in particular made of glass or made of organic polymer material, or on one face of a polymer interlayer sheet.

9. The layered element as claimed in any one of the preceding claims, **characterized in that** the central layer (3) is a stack of thin layers comprising an alternation of "n" metallic functional layers, in particular functional layers based on silver or on a metal alloy containing silver, and of "(n+1)" antireflection coatings, with n ≥ 1, where each metallic functional layer is positioned between two antireflection coatings.

10. The layered element as claimed in any one of the preceding claims, **characterized in that** the central layer (3) is an asymmetric stack of thin layers, the ratio of the total reflection ($R_e$) of the central layer (3) on the side turned toward the first outer layer (2) in said given wavelength range to the total light reflection ($R_i$) of the central layer (3) on the side turned toward the second outer layer (4) in said given wavelength range being greater than or equal to 1.5, preferably greater than or equal to 2.

11. The layered element as claimed in any one of the preceding claims, **characterized in that** the absolute value of the difference in refractive index at 550 nm between, on the one hand, the outer layers (2, 4) and, on the other hand, at least one layer made of dielectric material of the central layer (3), is greater than or equal to 0.30, preferably greater than or equal to 0.50.

12. The layered element as claimed in any one of the preceding claims, **characterized in that** the absolute value of the difference in refractive index at 550 nm between the constituent dielectric materials of the two outer layers (2, 4) is less than or equal to 0.150, preferably less than or equal to 0.050.

13. The layered element as claimed in any one of the preceding claims, **characterized in that** one of the two outer layers (2, 4) comprises a rigid or flexible substrate, in particular made of glass or made of organic polymer material, one main surface of which is textured.

14. The layered element as claimed in any one of claims 1 to 12, **characterized in that** one of the two outer layers (2, 4) comprises a conformable layer of which one main surface is textured and which is added via its other main surface to a rigid or flexible substrate.

15. The layered element as claimed in either one of claims 13 and 14, **characterized in that** the other outer layer (4, 2) comprises a sol-gel layer of matching refractive index comprising a silica-based organic/inorganic hybrid matrix.

16. The layered element as claimed in any one of the preceding claims, **characterized in that** the or each constituent layer of the central layer (3) is a layer deposited by sputtering onto a textured surface.

17. The layered element as claimed in any one of the preceding claims, **characterized in that** it comprises, on its outer main surface located on the side of the second outer layer (4), an antireflection coating (7') at the interface between the air and the constituent material of the layer forming this outer main surface.

18. The layered element as claimed in any one of the preceding claims, **characterized in that** the outer main surfaces of the layered element are curved.

19. A glazing for a vehicle, a building, street furniture, interior furnishings, lighting device, display support, projection screen, comprising at least one layered element (10) as claimed in any one of claims 1 to 18.

**Fig.1**

**Fig.2**

**Fig.3**

# Fig.4

**Fig.5**

**Fig.6**

**Fig.7**

Fig.8

EP 3 063 002 B1

Fig.9

**EP 3 063 002 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2012104547 A1
- WO 0248065 A1
- EP 0847965 A1